# EUROPEAN PATENT SPECIFICATION

(11) **EP 0 608 777 B1**
(45) Date of publication and mention of the grant of the patent: **11.09.1996**
(21) Application number: 94100858.3
(22) Date of filing: 21.01.1994
(51) Int. Cl.: G03F 7/07

(54) **Processing of lithographic printing material**
Bearbeitung von lithographischem Druckmaterial
Traitement de produit lithographique d'impression

(30) Priority: 29.01.1993 JP 34312/93
(43) Date of publication of application: 03.08.1994
(73) Proprietor: FUJI PHOTO FILM CO., LTD., Kanagawa 250-01 (JP)
(72) Inventor: Takagi, Yoshihiro, Minami-ashigara-shi, Kanagawa (JP)
(74) Representative: Grünecker, Kinkeldey, Stockmair & Schwanhäusser Anwaltssozietät

(56) References cited:
- EP-A- 0 423 399
- EP-A- 0 481 562
- EP-A- 0 556 885

## Description

This invention relates to a method for processing silver salt-base lithographic printing material, and more particularly, to a method for processing such lithographic printing material adapted for silver salt diffusion transfer which is suitable for laser exposure, and has excellent photographic properties, minimized scumming, improved ink receptivity and plate wear.

In the prior art, there are known a number of lithographic or planographic printing materials utilizing a silver salt transfer process. Typical printing materials have integrated together a photosensitive photographic element and a printing image element in the form of a physical development nucleus layer as disclosed in, for example, Japanese Patent Publication (JP-B) No. 42453/1971 and 30562/1973. They use conventional negative emulsions so that transferred silver images are positive. Systems for producing a transferred silver image as a negative image are also described in JP-B 13587/1986, 06108/1982, and 26019/1981, and Japanese Patent Unexamined Publication (JP-A) No. 173247/1986. These systems, however, are unacceptable in practice because of low sensitivity, shortage of transferred silver, and unsatisfactory properties as printing plates including ink receptivity, plate wear (also known as printing endurance or run length), and scumming (also known as toning).

The main stream method for processing lithographic printing material is a single bath method using a developer or activator containing a silver halide solvent as described in JP-A 19141/1985, 259666/1988, 198064/1988, 284147/1990, 235157/1992, and 295849/1992. Commercially available materials are Silver Master and Silver Digiplate manufactured by Mitsubishi Paper Mill K.K. and Super-Master manufactured by Agfa Gevaert A.G. These lithographic printing materials are processed with activators since developing agents have been incorporated therein. In the single bath processing, however, the activator must be at pH 12.5 or higher in order to provide an increased development rate because development must take place prior to dissolution of silver halide. The activator liquid is hazardous to handle and tends to absorb carbon dioxide from air to lower its pH, which is a bar against consistent processing. JP-A 235157/1992 discloses a developer containing a silver halide solvent. This developer has a reduced content of hydroquinone and is less stable. When this developer is used in single bath processing wherein development and dissolution take place simultaneously, printing properties including plate wear, ink receptivity and scumming are insufficient probably because of high pH.

Similar problems occur in single bath processing using activators. In addition, since developing agents must be incorporated in lithographic printing material, the material can be exacerbated in raw stock storability and printing properties.

With respect to the halogen composition of silver halide emulsions in lithographic printing materials, silver chloride base emulsions are practically used for increasing the development rate although they are difficult to provide high-illumination intensity (less than 10⁻³ sec.) sensitivity accommodating for various laser light sources such as He-Ne, LD, etc. Silver halide emulsions of the silver chloride system also suffer from the problem that the lithographic printing materials associated therewith have a short shelf life.

In accordance with the recent advance of the computer technology, attention is now paid to the direct process wherein printing plates are directly exposed to final images through an image setter using a laser or light-emitting diode light source. Under such circumstances, lithographic printing materials using silver chloride-base silver halide emulsions are limited in increasing high-illumination intensity sensitivity and in increasing resolving power at high contrast. There is a need for improvement in these respects.

A special processor must be purchased for the single bath development process because conventional automatic processors for printing plate films as exemplified by Model FG680A manufactured by Fuji Photo-Film Co., Ltd. cannot be used. There is a need for a processing technique which can be carried out with conventional automatic processors.

There is a desire to have a processing method which uses a safe processing system with ease of handling, offers improved photographic and printing properties, and is compatible with the direct process using laser light.

EP-A-0423399 discloses a method for preparing a conventional positive type DTR lithographic plate using a negative emulsion. The emulsion contains Rh and/or Ir dopants. The DTR material is processed with a single developing solution.

EP-A-0556885 discloses a positive type DTR lithographic plate using a conventional negative emulsion. It is characterized by the use of a development restraining agent. It discloses a two-bath processing, wherein the first bath contains hydrazine for fogging. The contents of hydroquinone in the first and second bath are different.

EP-A-0481562 relates to a negative type DTR lithographic plate using an internal latent image emulsion. The development step is carried out using two alkaline processing liquids, the first of which containing 24g/l of hydroquinone and the second of which containing 13g/l of hydroquinone.

It is the object of the present invention to provide a method for processing lithographic printing material utilizing dissolution physical development in a silver salt diffusion transfer process, thereby producing a lithographic printing plate featuring high sensitivity, high resolving power, and improved printing properties such as plate wear and ink receptivity, which can accommodate for high-illumination intensity light sources such as laser light having various wavelengths and which is capable of consistent processing and using a processing solution which is easy to handle.

Said object of the present invention is achieved by a method for processing a lithographic printing material having at least a silver halide emulsion layer and a physical development nucleus layer on a support by a processing procedure including at least development in accordance with a silver salt diffusion transfer process, wherein
said development is carried out in two baths, the first bath uses a developer which does not induce substantial diffusion transfer development, and the second bath uses a developer which contains a silver halide solvent necessary to induce diffusion transfer development,
wherein each of the first and second bath developers is at pH 10.0 to 12.3 and contains at least 20 g/l of hydroquinone.

Preferably, the silver halide emulsion is a negative emulsion, typically of the surface latent image type whereby a positive transfer silver image is produced. The silver halide emulsion includes a silver halide of a halogen composition containing at least 20 mol% of bromine. For improving sensitivity, especially high-illumination intensity sensitivity, the silver halide emulsion contains iridium and optionally rhodium.

Also preferably, the lithographic printing material contains a sensitizing dye.

Advantages of the present invention become evident by comparing it with several of the patent publications referred to above. JP-A 19141/1985 describes that a lithographic printing plate using a silver chloride-base emulsion to which an iridium compound is added for increasing sensitivity is processed with a transfer developer free of a developing agent. JP-A 284147/1990 describes a lithographic printing plate using a silver chloride-base emulsion containing iridium and having a grain size of at least 0.3 µm. These methods are coincident with the preferred embodiment of the present invention in that a silver halide emulsion containing iridium is used, but different from the present invention in that they use a transfer developer of the single bath system. No satisfactory printing properties are available with the conventional single bath system.

JP-A 259666/1988 describes a lithographic printing plate using a white pigment and having high sensitivity and resolving power. JP-A 198064/1988 describes a lithographic printing plate for high illumination intensity containing 1-phenyl-5-mercaptotetrazole. These plates also use a transfer developer of the single bath system, with which no satisfactory printing properties are available.

JP-A 71056/1984, 71055/1984, 179744/1985, 105147/1987, and 141561/1987 describe lithographic printing plates having sensitizing dyes combined with halogen compositions. These plates also use a transfer developer of the single bath system and are unsatisfactory in sensitivity, resolving power, and plate wear.

JP-A 13249/1986 and 196548/1983 describe lithographic printing plates containing fine particulate powder for improving printing properties. These plates also use a transfer developer of the single bath system and are unsatisfactory in resolving power and plate wear.

### Two bath system

According to the present invention, a lithographic printing material including at least a silver halide emulsion layer and a physical development nucleus layer on a support is processed by a silver salt diffusion transfer process.

The lithographic printing material is subject to two bath development. The first bath uses a developer which does not induce substantial diffusion transfer development, and the second bath uses a developer which contains a silver halide solvent necessary to induce diffusion transfer development. The developer of the first bath is a conventional developer in which dissolving power is controlled low by properly selecting the type and amount of a silver halide solvent, for example, a developer substantially free of a silver halide solvent. On the other hand, the developer of the second bath is a dissolution transfer developer having a high dissolving power to cause undeveloped silver halide to be transferred to physical development nuclei to precipitate as a silver image.

The two bath development system which allows conventional development (chemical development) and dissolution physical development to separately take place as mentioned above provides high sensitivity and better printing properties including resolving power and plate wear, as compared with the single bath development system of simultaneously performing chemical and physical developments. This is probably because of processing in separate baths whereby transfer silver images are improved in quality.

The two bath development system allows the developers to have lower pH because it is unnecessary to increase pH to increase a development rate for inducing development prior to dissolution of silver halide as required in the single bath development system. With the two bath development system at such lower pH, better printing properties are available.

In general, a lithographic printing plate has a printing surface including a lipophilic image area capable of receiving ink and a non-image area repellent to ink. Lithographic printing material utilizing a silver salt diffusion transfer process uses a silver image precipitated on the printing plate surface by the diffusion transfer process as the lipophilic image area and an area where no silver image is precipitated as the hydrophilic or ink-repellent non-image area. Lithographic printing is usually carried out using such a lithographic printing material, by supplying water and ink simultaneously to the plate surface so that the image area receives ink and the non-image area receives water both preferentially whereupon the ink on the image area is transmitted to an ink-receptive sheet, typically paper. Printed matter is obtained in this way. The key to satisfactory printed matter is a definite difference between image and non-image areas, that is, a definite difference between hydrophobic and hydrophilic properties. A lowering of pH is effective for enhancing such difference.

Since developers are lower in pH, processing becomes stable and easy.

These advantages are achieved with the two bath development system of the present invention while none of such advantages are obtained with the single bath development systems described in the above-referred patent publications despite various modifications made on lithographic printing material.

Better results are obtained from the lithographic printing material of the present invention when it uses a silver halide emulsion having a relatively high bromine content. It was believed in the art that such high bromine content emulsion was unsuitable for lithographic printing material because its development rate was too low to provide satisfactory silver transfer in the single bath development system where development and dissolution took place simultaneously. The two bath development system of the invention eliminates such restriction. The invention thus contributes to enhancement of high-illumination intensity sensitivity which was difficult with conventional commonly used AgCl base emulsions, enabling direct formation of printing plates using various laser light sources. Another advantage is improved shelf life as compared with the conventional AgCl base emulsions.

In the two bath development system of the present invention, each of the first and second baths may include a plurality of processing tanks while an intermediate processing bath such as an intermediate washing bath may intervene between the first and second baths. Where the first and/or second bath consists of a plurality of processing tanks, an intermediate washing tank may intervene between the tanks.

The second bath in the two bath development system of the present invention uses a developer which contains a silver halide solvent necessary to induce diffusion transfer development, more specifically a developer which contains a silver halide solvent necessary to complete substantial diffusion transfer development. The "substantial completion of diffusion transfer development" means to transfer part or all of undeveloped silver halide to the physical development nucleus layer to impart adequate endurance and other printing properties to the printing plate.

In contrast, the developer of the first bath is a developer which does not induce substantial diffusion transfer development, more specifically a developer which is free of a silver halide solvent necessary to complete substantial diffusion transfer development. The "developer which does not induce substantial diffusion transfer development" means that no transfer to the physical development nucleus layer takes place or that even when such transfer takes place, no adequate printing properties are imparted to the printing plate. Then the first bath developer can contain a small amount of a silver halide solvent, but its main purpose is to promote development or to adjust sensitivity and gradation.

More particularly, the second bath developer preferably contains at least 0.03 mol/liter, more preferably 0.05 to 0.8 mol/liter of a silver halide solvent. In contrast, the first bath developer preferably contains less than 0.02 mol/liter, more preferably 0 to 0.01 mol/liter of a silver halide solvent. Most preferably the silver halide solvent content is substantially zero. The "substantially zero content of silver halide solvent" means that the main purpose of adding a silver halide solvent is to adjust photographic properties as previously mentioned. Therefore it is meaningless if the presence of silver halide solvent exacerbates such photographic properties as sensitivity, gradation and Dmax. And even if the presence of silver halide solvent causes transfer, no adequate printing plate properties are imparted.

### Silver halide solvent

The silver halide solvents which can be added to the developers used herein include thiosulfates such as sodium thiosulfate, thiocyanates such as sodium thiocyanate and potassium thiocyanate, alkanol amines, cyclic imines, alkyl-substituted aminoalcohols, thioureas, thioethers, meso-ionic compounds, thiosalicylic acid, and aminothiosulfates. They may be used alone or in admixture. Preferred among others are thiosulfates, cyclic imines, alkyl-substituted aminoalcohols, thioureas, thioethers, and meso-ionic compounds.

The alkyl-substituted aminoalcohols which are useful silver halide solvents in the practice of the invention include primary, secondary and tertiary amine compounds having at least one hydroxyalkyl radical, preferably secondary and tertiary amine compounds. The alkyl-substituted aminoalcohols are represented by the following formula.

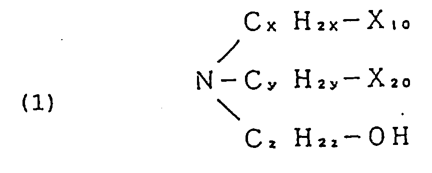

In formula (1), each of X₁₀ and X₂₀ is a hydrogen atom, hydroxyl radical or amino radical, x and y are 0 or integers of at least 1, and z is an integer of at least 1.

Examples include ethanolamine, diethanolamine, triethanolamine, diisopropanolamine, N-methylethanolamine (or 2-methylaminoethanol), N-aminoethylethanolamine (or 2-(2-aminoethylamino)ethanol), N,N-diethylethanolamine, N,N-dimethylethanolamine, N-methyldiethanolamine, N-ethyldiethanolamine, 3-aminopropanol, 1-amino-propan-2-ol, 4-aminobutanol, 5-amino-pentan-1-ol, 3,3'-iminodipropanol, and N-ethyl-2,2'-iminodiethanol.

Also useful are 2-amino-2-(hydroxymethyl)propane-1,3-diol and 2-amino-2-methylpropane-1,3-diol.

The meso-ionic compounds are preferably those of the following general formula: 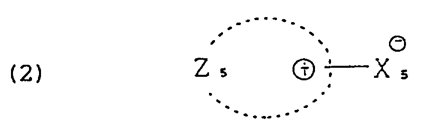 wherein Z₅ is a five or six-membered ring composed of atoms selected from the group cdnsisting of carbon, nitrogen, oxygen, sulfur, and selenium atoms, and
-X₅⁻ is -O⁻, -S⁻ or -N⁻R₅₀ wherein R₅₀ is selected from the group consisting of an alkyl, cycloalkyl, alkenyl, alkynyl, aralkyl, aryl, and heterocyclic radical,

In formula (2), Z₅ is a five or six-membered ring. Exemplary five-membered heterocyclic rings include imadazolium, pyrazolium, oxazolium, thiazolium, triazolium, tetrazolium, thiadiazolium, oxadiazolium, thiatriazolium and oxatriazolium rings. Exemplary six-membered heterocyclic rings include pyranes, dioxanes, pyridines, piperidines, quinolines, hydroquinolines, isoquinolines, diazines, piperadines, benzodiazines, triazines, tetrazines, pteridines, naphthilizines, quinolizines, oxazines, thiazines, thiadiazines, dithiazines, and oxadiazines. The five-membered rings are preferred.

R₅₀ represents a substituted or unsubstituted alkyl radical (e.g., methyl, ethyl, n-propyl, n-butyl, isopropyl, n-octyl, carboxyethyl, ethoxycarbonylmethyl, and dimethylaminoethyl radicals), a substituted or unsubstituted cycloalkyl radical (e.g., cyclohexyl and 4-methylcyclohexyl radicals), a substituted or unsubstituted alkenyl radical (e.g., propenyl radical), a substituted or unsubstituted alkynyl radical (e.g., propargyl and 1-methylpropargyl radicals), a substituted or unsubstituted aralkyl radical (e.g., benzyl and 4-methoxybenzyl radicals), a substituted or unsubstituted aryl radical (e.g., phenyl and 3-methoxyphenyl radicals), and a substituted or unsubstituted heterocyclic radical (e.g., pyridyl, imidazolyl, morpholino, triazolyl, tetrazolyl and thienyl radicals).

The heterocyclic ring represented by Z₅ may have a substituent or substituents, for example, a nitro radical, a halogen atom (e.g., chloro and bromo), a mercapto radical, a cyano radical, a substituted or unsubstituted alkyl radical (e.g., methyl, ethyl, propyl, methoxyethyl, methylthioethyl, dimethylaminoethyl, trimethylammonioethyl, carboxymethyl, carboxyethyl, carboxypropyl, sulfoethyl, sulfomethyl, phosphonomethyl, and phosphonoethyl radicals), a substituted or unsubstituted aryl radical (e.g., phenyl and 4-sulfophenyl radicals), a substituted or unsubstituted alkenyl radical (e.g., allyl radical), a substituted or unsubstituted cycloalkyl radical (e.g., cyclohexyl radical), a substituted or unsubstituted alkynyl radical (e.g., propargyl radical), a substituted or unsubstituted aralkyl radical (e.g., benzyl and 4-methylbenzyl radicals), a substituted or unsubstituted alkoxy radical (e.g., methoxy, ethoxy and methoxyethoxy radicals), a substituted or unsubstituted aryloxy radical (e.g., phenoxy radical), a substituted or unsubstituted alkylthio radical (e.g., methylthio and ethylthio radicals), a substituted or unsubstituted arylthio radical (e.g., phenylthio radical), a substituted or unsubstituted sulfonyl radical (e.g., methanesulfonyl and p-toluenesulfonyl radicals), a substituted or unsubstituted carbamoyl radical (e.g., carbamoyl and methylcarbamoyl radicals), a substituted or unsubstituted thiocarbamoyl radical (e.g., dimethylthiocarbamoyl radical), a substituted or unsubstituted sulfamoyl radical (e.g., sulfamoyl, methylsulfamoyl and phenylsulfamoyl radicals), a substituted or unsubstituted carbonamido radical (e.g., acetamido, benzamido and methoxypropionamido radicals), a substituted or unsubstituted sulfonamido radical (e.g., methanesulfonamido and benzenesulfonamido radicals), a substituted or unsubstituted acyloxy radical (e.g., acetyloxy and benzoyloxy radicals), a substituted or unsubstituted sulfonyloxy radical (e.g., methanesulfonyloxy radical), a substituted or unsubstituted ureido radical (e.g., ureido, methylureido, ethylureido and methoxyethylureido radicals), a substituted or unsubstituted thioureido radical (e.g., thioureido, methylthioureido and methoxyethylthioureido radicals), a substituted or unsubstituted sulfamoylamino radical (e.g., sulfamoylamino and dimethylsulfamoylamino radicals), a substituted or unsubstituted acyl radical (e.g., acetyl and 4-methorybenzoyl radicals), a substituted or unsubstituted thioacyl radical (e.g., thioacetyl radical), a substituted or unsubstituted heterocyclic radical (e.g., 1-morpholino, 1-pyperidino, 2-pyridyl, 4-pyridyl, 2-thienyl, 1-pyrazolyl, 1-imidazolyl, 2-tetrahydrofuryl, and tetrahydrothienyl radicals), a substituted or unsubstituted oxycarbonyl radical (e.g., methoxycarbonyl, phenoxycarbonyl and methoxyethoxycarbonyl radicals), a substituted or unsubstituted oxycarbonylamino radical (e.g., methoxycarbonylamino radical), a substituted or unsubstituted amino radical (e.g., amino and dimethylamino radicals), a carboxylic acid or a salt thereof, a sulfonic acid or a salt thereof, and a hydroxyl radical.

The compounds of formula (2) may form salts, for example, with acetic acid, nitric acid, salicylic acid, hydrochloric acid, iodic acid, bromic acid, etc.

In formula (2), X₅⁻ is preferably -S⁻.

More preferred among the meso-ionic compounds are those of the general formula: 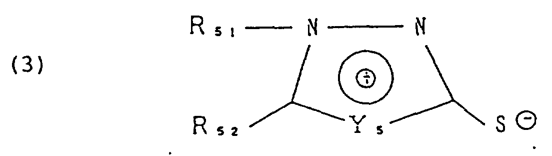 wherein R₅₁ and R₅₂ are independently selected from the group consisting of an alkyl, cycloalkyl, alkenyl, alkynyl, aralkyl, aryl, and heterocyclic radical, or R₅₂ may also be a hydrogen atom, and
Y₅ is -O-, -S-, or -N(R₅₃)- wherein R₅₃ is selected from the group consisting of an alkyl, cycloalkyl, alkenyl, alkynyl, aryl, heterocyclic, amino, acylamino, sulfonamido, ureido, and sulfamoylamino radical, or
R₅₁ and R₅₂, and R₅₂ and R₅₃, taken together, may form a ring.

More particularly, R₅₁ and R₅₂ in formula (3) represent a substituted or unsubstituted alkyl radical (e.g., methyl, ethyl, n-propyl, t-butyl, methoxyethyl, methylthioethyl, dimethylaminoethyl, morpholinoethyl, dimethylaminoethylthioethyl, diethylaminoethyl, aminoethyl, methylthiomethyl, trimethylammonioethyl, carboxymethyl, carboxyethyl, carboxypropyl, sulfoethyl, sulfomethyl, phosphonomethyl and phosphonoethyl radicals), a substituted or unsubstituted cycloalkyl radical (e.g., cyclohexyl, cyclopentyl and 2-methylcyclohexyl radicals), a substituted or unsubstituted alkenyl radical (e.g., allyl and 2-methylallyl radicals), a substituted or unsubstituted alkynyl radical (e.g., propargyl radical), a substituted or unsubstituted aralkyl radical (e.g., benzyl, phenethyl and 4-methoxybenzyl radicals), a substituted or unsubstituted aryl radical (e.g., phenyl, naphthyl, 4-methylphenyl, 4-methoxyphenyl, 4-carboxyphenyl and 4-sulfophenyl radicals), and a substituted or unsubstituted heterocyclic radical (e.g., 2-pyridyl, 3-pyridyl, 4-pyridyl, 2-thienyl, 1-pyrazolyl, 1-imidazolyl and 2-tetrahydrofuryl radicals). R₅₂ may also represent a hydrogen atom.

R₅₃ represents a substituted or unsubstituted alkyl radical (e.g., methyl, ethyl, n-propyl, t-butyl, methoxyethyl, methylthioethyl, dimethylaminoethyl, morpholinoethyl, dimethylaminoethylthioethyl, diethylaminoethyl, aminoethyl, methylthiomethyl, trimethylammonioethyl, carboxymethyl, carboxyethyl, carboxypropyl, sulfoethyl, sulfomethyl, phosphonomethyl and phosphonoethyl radicals), a substituted or unsubstituted cycloalkyl radical (e.g., cyclohexyl, cyclopentyl and 2-methylcyclohexyl radicals), a substituted or unsubstituted alkenyl radical (e.g., allyl and 2-methylallyl radicals), a substituted or unsubstituted alkynyl radical (e.g., propargyl radical), a substituted or unsubstituted aralkyl radical (e.g., benzyl, phenethyl and 4-methoxybenzyl radicals), a substituted or unsubstituted aryl radical (e.g., phenyl, naphthyl, 4-methylphenyl, 4-methoxyphenyl, 4-carboxyphenyl and 4-sulfophenyl radicals), a substituted or unsubstituted heterocyclic radical (e.g., 2-pyridyl, 3-pyridyl, 4-pyridyl, 2-thienyl, 1-pyrazolyl, 1-imidazolyl and 2-tetrahydrofuryl radicals), a substituted or unsubstituted amino radical (e.g., amino, dimethylamino and methylamino radicals), a substituted or unsubstituted acylamino radical (e.g., acetylamino, benzoylamino and methoxypropionylamino radicals), a substituted or unsubstituted sulfonamido radical (e.g., methanesulfonamido, benzenesulfonamido and 4-toluenesulfonamido radicals), a substituted or unsubstituted ureido radical (e.g., ureido and 3-methylureido radicals), and a substituted or unsubstituted sulfamoylamino radical (e.g., sulfamoylamino and 3-methylsulfamoylamino radicals).

Preferably, Y₅ represents -N(R₅₃)-; R₅₁ and R₅₃ represent a substituted or unsubstituted alkyl radical, a substituted or unsubstituted alkenyl radical, a substituted or unsubstituted alkynyl radical, or a substituted or unsubstituted heterocyclic radical; and R₅₂ represents a hydrogen atom, a substituted or unsubstituted alkyl radical, a substituted or unsubstituted alkenyl radical, a substituted or unsubstituted alkynyl radical, or a substituted or unsubstituted heterocyclic radical.

Several illustrative, non-limiting examples of the meso-ionic compound are given below as Compound Nos. 1 to 19.

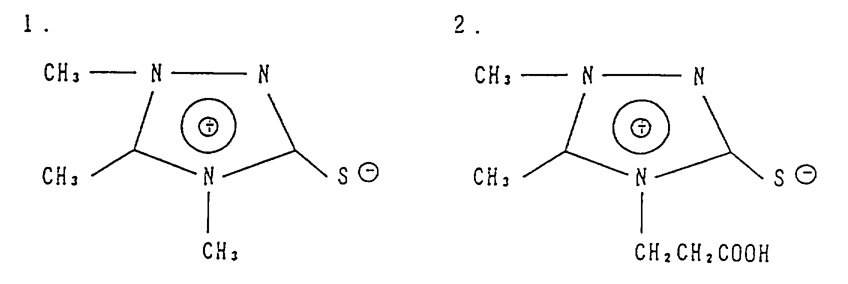

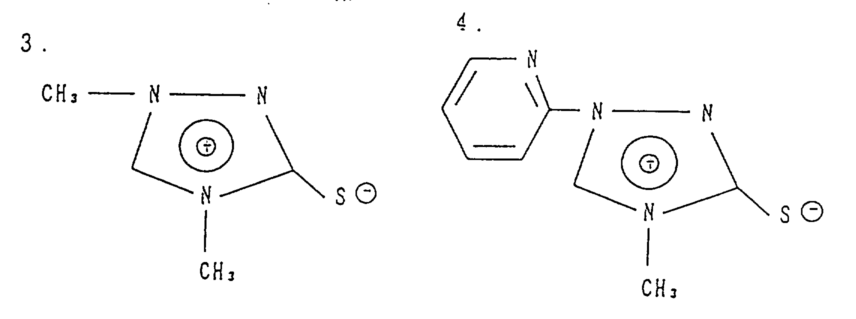

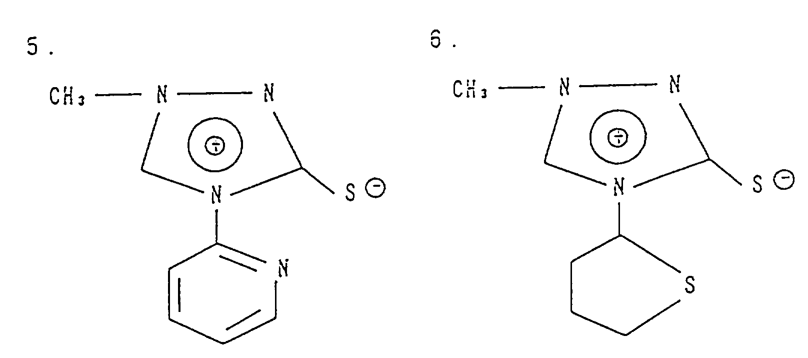

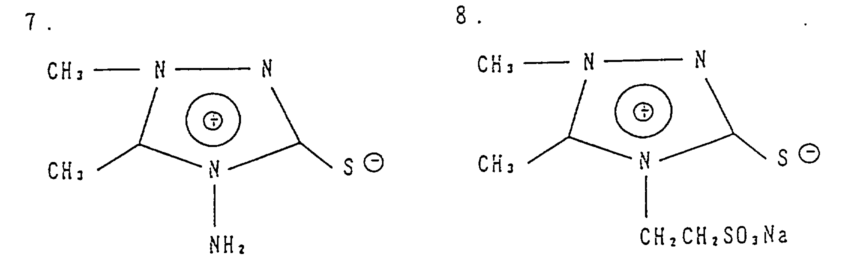

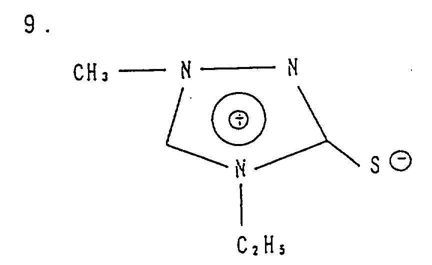

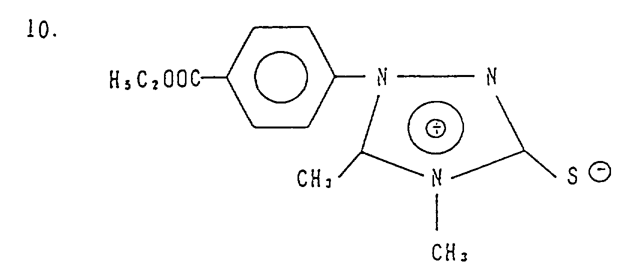

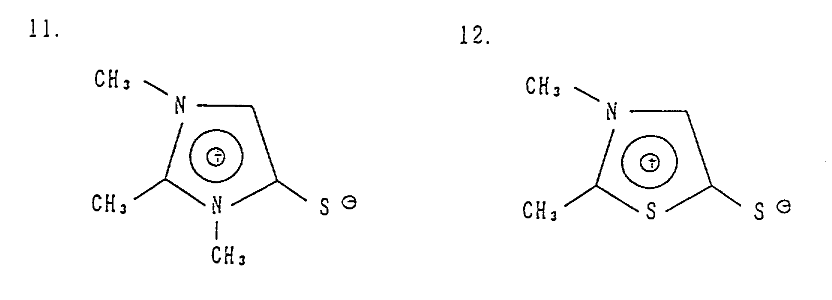

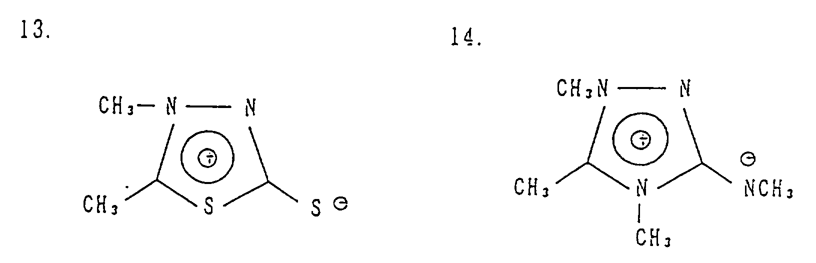

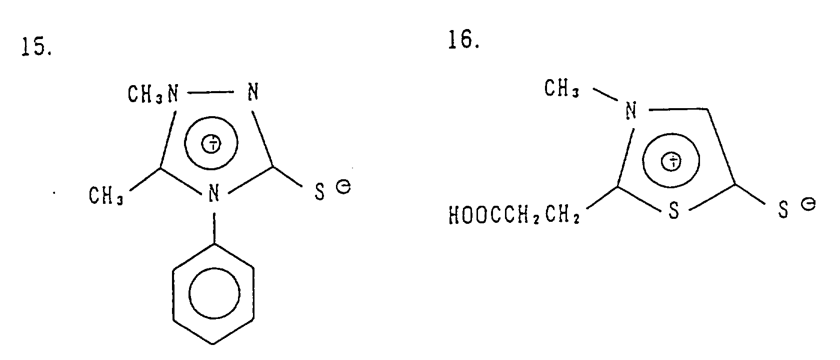

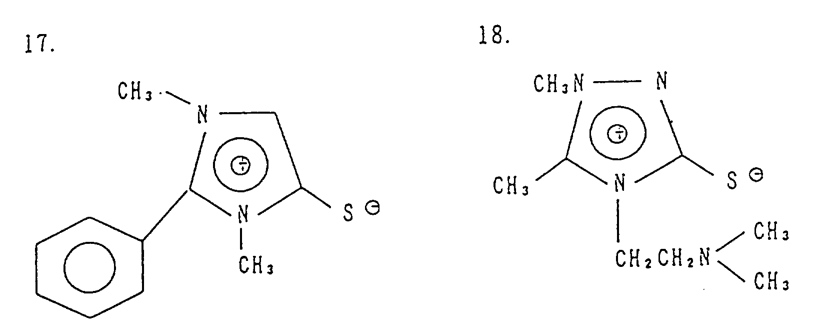

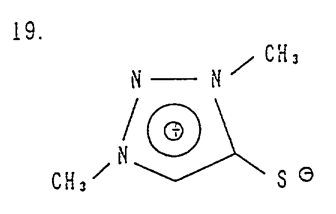

The meso-ionic compounds of formula (2) can be synthesized by conventional methods known in the literature, for example, J. Heterocyclic Chem., 2, 105 (1965), ibid., 5, 277 (1968), J. Org. Chem., 30, 567 (1965), ibid., 32, 2245 (1967), J. Chem. Soc., 899 (1935), ibid., 2865 (1959), ibid., 3799 (1969), J. Chem. Soc., Perkin Trans. I, 627 (1974), J. Am. Chem. Soc., 80, 1895 (1958), Chem. Commun., 1222 (1971), Tetrahedron Letters, 5881 (1968), ibid., 1578 (1971), ibid., 2939 (1972), ibid., 1809 (1976), Berichte der Deutschen Chemischen Gesellshaft, 38, 4049 (1905), J. Chem. Soc. Chem. Commun., 1224 (1971), and Advances in Heterocyclic Chemistry, 19, 1 (1976) as well as JP-A 87322/1985, JP-A 117240/1985, JP-A 122936/1985.

Preferred thioureas used herein are tetra-substituted thioureas of the following formula.

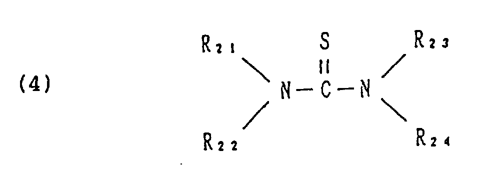

In formula (4), R₂₁, R₂₂, R₂₃, and R₂₄ are independently selected from a substituted or unsubstituted alkyl radical, a substituted or unsubstituted alkenyl radical (e.g., allyl radical), and a substituted or unsubstituted aryl radical. The total number of carbon atoms in R₂₁ to R₂₄ is preferably up to 30. Alternatively, R₂₁ and R₂₂, R₂₂ and R₂₃, or R₂₃ and R₂₄ taken together may form a five or six-membered heterocyclic ring such as imidazolidinethion, piperidine, and morpholine rings. The alkyl radical may be either linear or branched. Substituents on the alkyl radical include a hydroxyl radical (-OH), carboxy radical, sulfonate radical, amino radical, alkoxy radical in which the alkyl moiety has 1 to 5 carbon atoms (O-alkyl radical), phenyl radical, and five or six-membered heterocyclic ring (e.g., furan). Substituents on the aryl radical include a hydroxy radical, carboxy radical and sulfonate radical.

More preferably three or more of R₂₁ to R₂₄ are alkyl radicals each having 1 to 5 carbon atoms, the remaining one if left is an aryl radical, typically phenyl, and the total number of carbon atoms in R₂₁ to R₂₄ is up to 20.

Illustrative examples of the thiourea used herein are given below as Compounds I-1 to I-11.

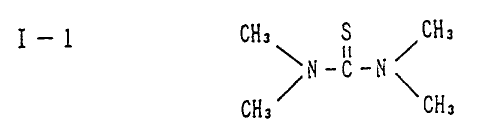

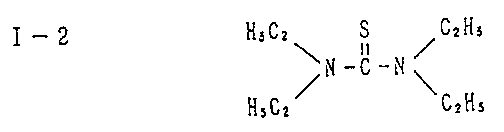

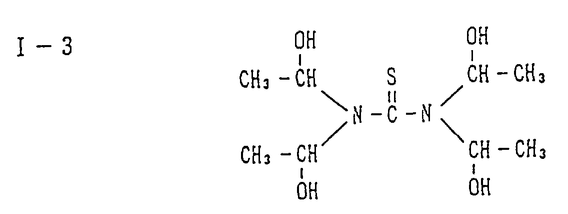

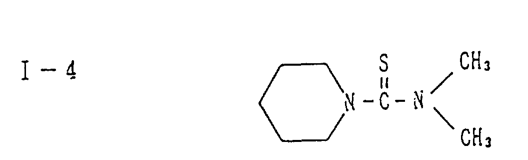

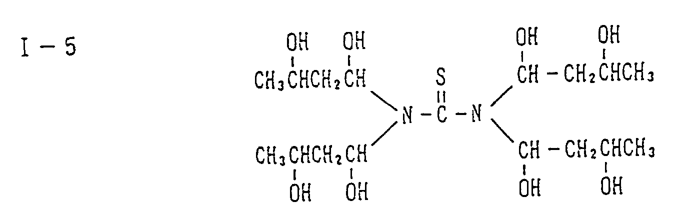

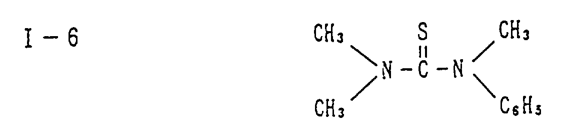

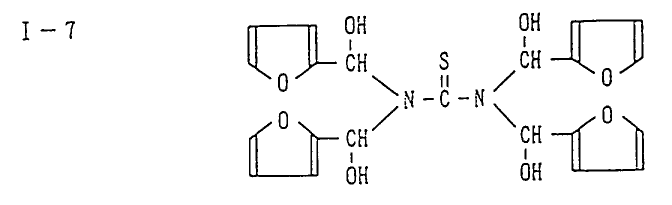

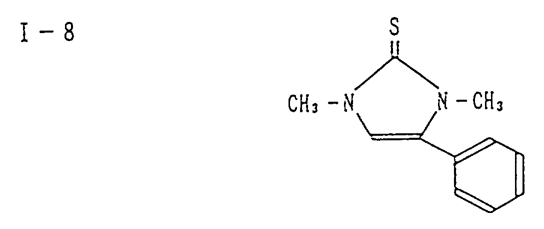

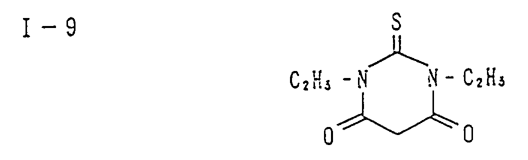

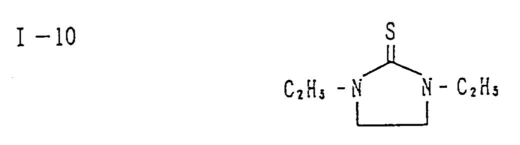

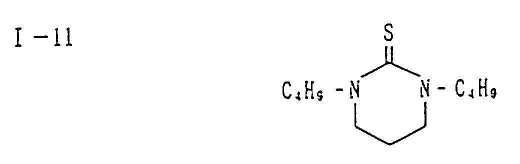

These compounds can be synthesized by conventional methods known in the literature, for example, J. Braun and K. Weizbach, Berichte der Deutschen Chemischen Geselschaft, 63, 2846 (1930), V. Mozoli and S. Jokubaityte, Lietuvos T S R Mokslu Akademijos Darbai, Ser. B, 1969 (3), 125-31, H. Weidinger and H. Eilingsfeld, German Patent No. 1119843, R. A. Donia et al., Journal of Organic Chemistry, 14, 946-951 (1949), F. B. Zienty, Journal of American Chemical Society, 68, 1388-1389 (1946), and L. G. S. Brooker et al., Journal of American Chemical Society, 73, 5829-5832 (1951).

Preferred thioethers used herein are organic thioether compounds represented by the following formulae (5) and (6).

(5) Q₃₁-[(CH₂)ₜ₁-CH₂-S-(CH₂)₂-X₃₁-(R₃₁)ₛ₁- (CH₂)₂-(R₃₂)_{w1}-S-CH₂-(CH₂)ₘ₁-Z₃₁]ₙ₁

(6) Q₃₁-(CH₂)ₘ₁-CH₂-S-(CH₂)ₙ₁-S-CH₂-(CH₂)ₜ₁-Z₃₁

In formulae (5) and (6), each of tl and ml is an integer of 0 to 4, nl is an integer of 1 to 4, and each of sl and wl is an integer of 0 to 3. In formula (5), X₃₁ is an oxygen atom, sulfur atom, -CONH-, -CO-, or -CO-O-, and each of R₃₁ and R₃₂ is an ethylene oxide radical. In formulae (5) and (6), each of Q₃₁ and Z₃₁ is -CONH₂, -OR₃₃, or -CO-OR₃₃ wherein R₃₃ is a hydrogen atom or an alkyl radical having 1 to 5 carbon atoms. Alternatively, each of Q₃₁ and Z₃₁ is a substituent represented by X₃₁, and in this case, they may be taken together to form a cyclic compound.

Preferred examples of the thioethers of formulae (5) and (6) are shown below.

HO-R₃₆-(S-R₃₈)ₜ₂-S-R₃₆-OH

(HO-R₃₆-S-R₃₆-O-R₃₈-)₂

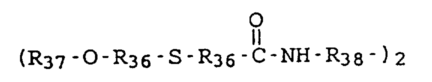

(R₃₇-O-R₃₆-S-R₃₆-)₂S

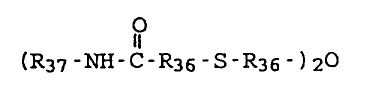

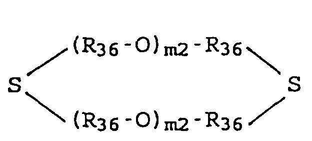

In these formulae, R₃₆ and R₃₈ are alkylene radicals having 1 to 5 carbon atoms such as methylene and ethylene radicals, R₃₇ is an alkyl radical having 1 to 5 carbon atoms such as an ethyl radical, t2 is an integer of 0 to 3, and m2 is 1 or 2.

Illustrative examples of the organic thioether compound are given below as Compounds II-1 to II-14.

II-1 HO(CH₂)₂-S-(CH₂)₂-S-(CH₂)₂OH

II-2 HO(CH₂)₃-S-(CH₂)₂-S-(CH₂)₃OH

II-3 HO(CH₂)₂-S-(CH₂)₂-S-(CH₂)₂-S-(CH₂)₂OH

II-4 [HO-(CH₂)₂-S-(CH₂)₂O-CH₂-]₂

II-5 [HO-(CH₂)₅-S-(CH₂)₅O-(CH₂)₂-]₂

II-6 [H₅C₂-O-(CH₂)₂-S-(CH₂)₅-]S

II-7 [H₃C-O-(CH₂)₄-S-(CH₂)₄-]S

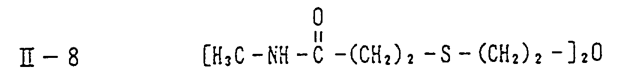

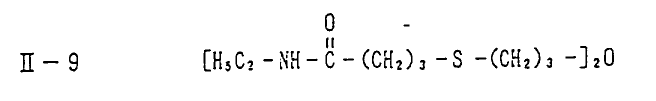

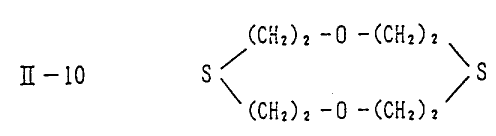

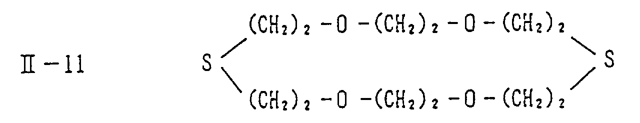

II-12 [NH₂CO(CH₂)₂-S-(CH₂)₂CONH-CH₂-]₂

II-13 HOOC-CH₂-S-(CH₂)₂-S-CH₂-COOH

II-14 HO(CH₂)₂-S-(CH₂)₂OH

The organic thioether compounds used herein may be synthesized by any desired method. Conventional methods may be used while reference is made to, for example, UKP 950089, USP 302121, and Journal of Organic Chemistry, 26, 1991-1995 (1961).

Also useful are those thioethers described in JP-A 1019/1979 and 158917/1979, typically CH₃-S-CH₂CH₂-S-CH₂CH₂-NH₂.

The cyclic imines used herein include those described in USP 2,857,276 while the compounds of the following formulae are preferred.

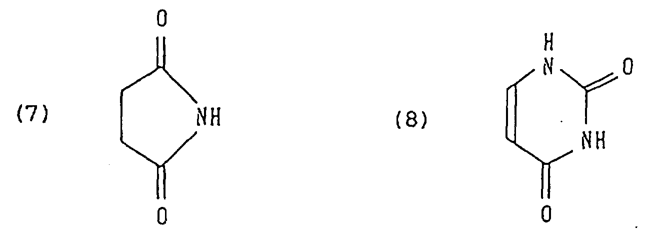

Also useful are the amine thiosulfates described in USP 3,169,962.

### Developers

The developer used in the present invention, whether it is either the first or second bath, is a developer containing a developing agent, but not an activator substantially free of a developing agent. This substantially eliminates a need for incorporating a developing agent in a lithographic printing material, which contributes to improvements in the sensitivity and printing properties of the lithographic printing material as well as the shelf life thereof.

The developers of both the first and second baths are at pH 10.0 to 12.3, preferably at pH 10.2 to 11.8. This pH range is lower than the pH value used in the conventional single bath development system and leads to safety and ease of handling.

Hydroquinone is used. Developers containing 20 to 80 g/liter of hydroquinone are preferred. Developers containing less amounts of hydroquinone would be less stable and less effective for providing printing properties such as resolving power and plate wear.

Other useful developing agents are 3-pyrazolidones such as 1-phenyl-3-pyrazolidone, 1-p-tolyl-3-pyrazolidone, 1-phenyl-4-methyl-3-pyrazolidone, 1-phenyl-4,4-dimethyl-3-pyrazolidone, 1-p-chlorophenyl-3-pyrazolidone, 1-p-methoxy-phenyl-3-pyrazolidone, 1-phenyl-2-acetyl-3-pyrazolidone, 1-phenyl-5,5-dimethyl-3-pyrazolidone, 1-o-chlorophenyl-4-methyl-4-ethyl-3-pyrazolidone, 1-m-acetamidophenyl-4,4-diethyl-3-pyrazolidone, 1,5-diphenyl-3-pyrazolidone, 1-(m-tolyl)-5-phenyl-3-pyrazolidone, 4,4-dihydroxymethyl-1-phenyl-3-pyrazolidone, 4,4-dihydroxymethyl-1-tolyl-3-pyrazolidone, 4-hydroxymethyl-4-methyl-1-phenyl-3-pyrazolidone, and 4-hydroxymethyl-4-methyl-1-(p-chlorophenyl)-3-pyrazolidone.

Also useful are aminophenols such as p-(methylamino)-phenol, p-aminophenol, 2,4-diaminophenol, p-(benzylamino)-phenol, 2-methyl-4-aminophenol, and 2-hydroxymethyl-4-aminophenol. Ascorbic acid may also be used.

The developing agents may be used alone or in combination. Combinations of hydroquinone with 3-pyrazolidones are especially preferred. The amount of 3-pyrazolidone used is about 0.1 to 30% by weight of the amount of hydroquinone.

For adjusting the pH of the developers to the range between 10.0 and 12.3, any of alkaline agents and pH adjusting or buffer agents may be added in an appropriate amount. Examples of the alkaline agent include hydroxides, carbonates and phosphates of alkali metals and ammonium, and examples of the pH adjusting agents include weak acids such as acetic acid and sulfuric acid, weak bases, and salts thereof.

Various other compounds may be added to the developers. Typical additives include development accelerators, for example, pyridinium compounds and cationic compounds as described in USP 2,648,604 and 3,671,247, potassium nitrate and sodium nitrate, polyethylene glycol condensates and derivatives thereof as described in USP 2,533,990, 2,577,127, and 2,950,970, nonionic compounds such as polythio ethers as typified by the compounds described in UKP 1,020,032 and 1,020,033, polymers having a sulfite ester as typified by the compounds described in USP 3,068,097, organic amines such as pyridine, ethanol amine and cyclic amines, benzyl alcohol, and hydrazines; antifoggants, for example, alkali chlorides, alkali bromides, alkali iodides, nitrobenzimidazoles as described in USP 2,496,940 and 2,656,271, mercaptobenzimidazole, 5-methylbenzotriazole, and 1-phenyl-5-mercaptotetrazole, compounds for rapid processing solutions as described in USP 3,113,864, 3,342,596, 3,295,976, 3,615,522, and 3,597,199, thiosulfonyl compounds as described in UKP 972,211, phenazine-N-oxides as described in JP-B 41675/1971, and fog suppressing agents as described in "Scientific Photography Manual", Mid Volume, pages 29-47; anti-stain or sludge agents as described in USP 3,161,513, 3,161,514, UKP 1,030,442, 1,144,481 and 1,251,558, and preservatives, for example, sulfites, acidic sulfites, hydroxylamine hydrochloride, formsulfite, and alkanolamine sulfite adducts. Also useful are metal blocking agents such as sodium hexametaphosphate and ethylenediaminetetraacetic acid and humectants such as saponin and ethylene glycol.

In the two bath development system using developers as defined above, the processing conditions include a temperature of about 20 to 40°C and a time of about 10 to 60 seconds for both the first and second baths.

If it is desired to stop development after the offset printing material of the present invention is developed, a neutralizing solution is used. The neutralizing solution may be a conventional acidic stop bath, typically adjusted at pH 3.0 to 8.0. The neutralizing solution may contain a water softening agent, pH adjusting agent, buffer agent and hardener while colloidal silica or polyols may be added for the purpose of avoiding ink staining of the printing plate being processed therewith.

The printing material is processed as described above to obtain a printing plate which is post-treated in various ways for the purpose of improving the printability thereof. For improving ink receptivity, for example, the printing plate may be treated by the methods described in USP 3,592,647, 3,490,906, and 3,161,508, and JP-B 10910/1971, 29723/1973, 15762/1976, and 15762/1977.

### Printing material

The lithographic printing material used in the present invention includes a silver halide emulsion layer. The silver halide emulsion used herein is not critical although a negative emulsion capable of producing a positive transfer silver image is preferred. More particularly the emulsion is a surface latent image type emulsion. Typical silver halide compositions are silver chloride, silver bromide, and silver halide mixes such as silver chlorobromide, silver chloroiodobromide, and silver iodobromide. The preferred silver halides used herein are silver chloro(iodo)bromide, silver (iodo)chloride and silver (iodo)bromide which are free of silver iodide or contain less than 3 mol% of silver iodide if any. It is especially preferred to use silver chloro(iodo)bromide and silver (iodo)bromide containing more than 20 mol% of bromine. Although an emulsion with a silver halide composition having a relatively high bromine content was believed as failing to provide satisfactory properties in the conventional single bath development system as previously mentioned, the present invention can derive satisfactory properties from such a high-bromide emulsion while the emulsion is optimum for high-illumination intensity exposure.

The silver halide grains preferably have a mean grain size of from 0.1 to 2 µm, more preferably from 0.15 to 1 µm. For spherical or nearly spherical grains, the mean grain size is an average of the diameters of grains and for cubic grains, it is an average based on the projected areas of grains with the side length being the grain size. The grain size distribution may be either narrow or broad although a commonly known "monodispersed" silver halide emulsion having a narrow grain size distribution that more than 90%, especially more than 95% based on grain number or weight of the entire grains fall within ±40%, more preferably within ±30%, most preferably within ±20% of the mean grain size is preferred for improving graininess and sharpness. To satisfy the designed-for gradation of the lithographic printing material, in emulsion layers having substantially identical color sensitivity, two or more monodispersed silver halide emulsions having different grain sizes or two or more silver halide emulsions containing grains of the same size, but of different sensitivities may be mixed in a single layer or coated as separate layers in an overlapping manner. Alternatively, two or more poly-dispersed silver halide emulsions or a mono-dispersed emulsion and a poly-dispersed emulsion may be mixed or overlapped.

The silver halide grains may have a regular crystal form such as cubic, octahedral, dodecahedral (12-sided) and tetradecahedral (14-sided) forms, an irregular crystal form such as spherical form, and a composite form of these crystal forms. Also plate grains are acceptable, and especially useful are emulsions wherein plate grains having an aspect (length/breadth) ratio of at least 5, especially at least 8 occupy at least 50% of the overall projected areas of grains. Emulsions containing a mixture of different crystal form grains are also useful.

As used herein, the silver halide emulsion may be prepared in the presence of a silver halide solvent. Examples of the silver halide solvent include organic thioethers as described in USP 3,271,157, 3,531,289, and 3,574,628 and JP-A 001019/1979 and 158917/1979, and thiourea derivatives as described in JP-A 082408/1978, 077737/1980 and 002982/1980.

In the preparation of such emulsions, grains may be doped with metals such as Ir, Rh, Ru, Pd, Pt, Pb and Fe during grain formation. Iridium (Ir) doping, especially iridium (Ir) and rhodium (Rh) doping is preferred since sensitivity, especially high-illumination intensity sensitivity (less than 10⁻³ sec.) can be increased as well as printing properties.

Silver halide grains may be doped with iridium or other metals by forming grains in the presence of a water-soluble metal salt such as ammonium iridium (IV) chloride and ammonium rhodium (III) chloride. The amount of Ir doped may be about 10⁻⁴ to 10⁻⁸ mol per mol of Ag. The amount of Rh doped in addition to Ir may be about 10⁻⁵ to 10⁻⁸ mol per mol of Ag.

The silver halide emulsion used herein may be chemically sensitized by effecting sulfur or selenium sensitization, reducing sensitization or noble metal sensitization alone or in combination within or on silver halide grains.

To the lithographic printing material of the invention there may be added sensitizing dyes (e.g., cyanine dyes and merocyanine dyes) for the purpose of increasing sensitivity as described in JP-A 052050/1980, pages 45-53.

The sensitizing dyes may be used alone or in combination of two or more. A combination of sensitizing dyes is frequently used for supersensitization. Along with the sensitizing dye, a dye which itself is free of spectral sensitizing ability or a substance which does not substantially absorb visible light, but contributes to supersensitization may be contained in the emulsion.

Useful sensitizing dyes, dye combinations providing supersensitization and substances contributing to supersensitization are described in the foregoing patents as well as Research Disclosure, Vol. 176, 17643 (December 1978), page 23, items IV-A to J.

It will be understood that the sensitizing dyes or the like may be added at any step of the emulsion preparation process and at any stage after the end of preparation until coating. For example, they may be added at the step of grain formation, physical ripening or chemical ripening.

The sensitizing dye used herein may be selected from orthochromatic sensitizing dyes, panchromatic sensitizing dyes, and infrared sensitising dyes in accordance with a particular high-illumination intensity light source such as conventional tungsten halide lamps and Ar, He-Ne and semiconductor lasers.

Preferred sensitizing dyes are shown below.

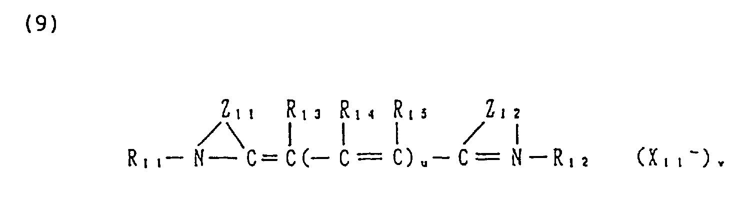

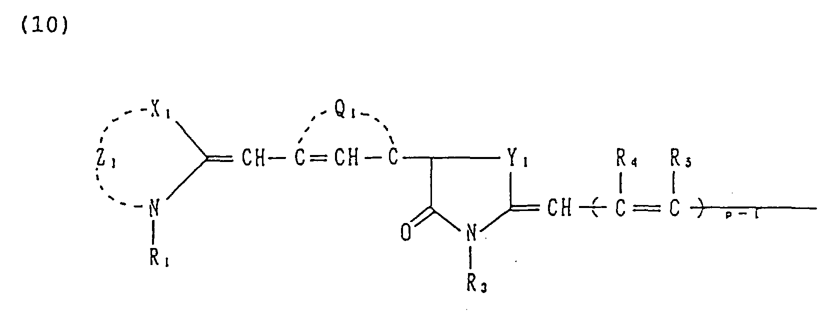

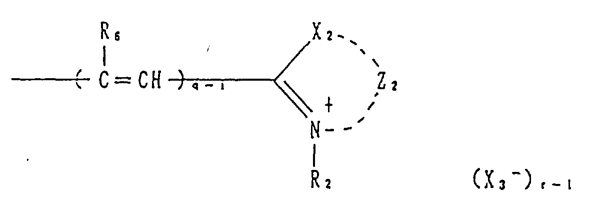

In formula (9), Z₁₁ and Z₁₂, which may be identical or different, each represent a group of atoms forming a five or six-membered nitrogenous heterocyclic ring with the nitrogen and carbon atoms, and letter u is equal to 0 or 1. R₁₁ and R₁₂, which may be identical or different, each represent a substituted or unsubstituted alkyl or alkenyl radical having up to 10 carbon atoms in total. R₁₃ and R₁₅ represent hydrogen atoms, or R₁₃ and R₁₁ taken together and R₁₅ and R₁₂ taken together may form a five or six-membered ring. R₁₄ is a hydrogen atom or a lower alkyl radical which may have a substituent. X₁₁ is an acid anion residue. Letter v is equal to 0 or 1. In the case of an internal salt, v is 0.

Preferred heterocyclic rings formed by Z₁₁ or Z₁₂ are shown below. Where u is equal to 0, Z₁₁ and Z₁₂ may be identical or different and form heterocyclic rings including thiazole, benzothiazole, naphthothiazole, dihydronaphthothiazole, selenazole, benzoselenazole, naphthoselenazole, dihydronaphthoselenazole, oxazole, benzoxazole, naphthoxazole, benzimidazole, naphthoimidazole, pyridine, quinoline, imidazo[4,5-b]quinoxaline, and 3,3-dialkylindolenine rings. Where u is equal to 1, the preferred heterocyclic rings formed by Z₁₁ include thiazoline, thiazole, benzothiazole, selenazoline, selenazole, benzoselenazole, oxazole, benzoxazole, naphthoxazole, imidazole, benzimidazole, naphthoimidazole, and pyrroline rings and the preferred heterocyclic rings formed by Z₁₂ include oxazoline, oxazole, benzoxazole, naphthoxazole, thiazoline, selenazoline, pyrroline, benzimidazole, and naphthoimidazole rings.

The nitrogenous heterocyclic rings formed by Z₁₁ or Z₁₂ may have one or more substituents. Preferred substituents include lower alkyl radicals which may be branched or which may, in turn, have a substituent (e.g., hydroxy radical, halogen atom, aryl, aryloxy, arylthio, carboxy, alkoxy, alkylthio, and alkoxycarbonyl radical), more preferably alkyl radicals having up to 10 carbon atoms in total, for example, methyl, ethyl, butyl, chloroethyl, 2,2,3,3-tetrafluoropropyl, hydroxyethyl, benzyl, tolylethyl, phenoxyethyl, phenylthioethyl, carboxypropyl, methoxyethyl, ethylthioethyl, and ethoxycarbonylethyl radicals; lower alkoxy radicals which may, in turn, have a substituent (which is the same as the exemplary substituents on the alkyl radicals), more preferably alkoxy radicals having up to 8 carbon atoms in total, for example, methoxy, ethoxy, pentyloxy, ethoxymethoxy, methylthioethoxy, phenoxyethoxy, hydroxyethoxy, and chloropropoxy radicals; a hydroxy radical; halogen atoms; a cyano radical; a thienyl radical; aryl radicals, for example, phenyl, tolyl, anisil, chlorophenyl and carboxyphenyl radicals; aryloxy radicals, for example, tolyloxy, anisiloxy, phenoxy and chlorophenoxy radicals; arylthio radicals, for example, tolylthio, chlorophenylthio and phenylthio radicals; lower alkylthio radicals which may, in turn, have a substituent (which is the same as the exemplary substituents on the alkyl radicals), more preferably alkylthio radicals having up to 8 carbon atoms in total, for example, methylthio, ethylthio, hydroxyethylthio, carboxyethylthio, chloroethylthio and benzylthio radicals; acylamino and sulfonylamino radicals, more preferably acylamino radicals having up to 8 carbon atoms in total, for example, acetylamino, benzoylamino, methanesulfonylamino and benzenesulfonylamino radicals; a carboxy radical; lower alkoxycarbonyl radicals, more preferably alkoxycarbonyl radicals having up to 6 carbon atoms in total, for example, ethoxycarbonyl and butoxycarbonyl radicals; perfluoroalkyl radicals, more preferably perfluoroalkyl radicals having up to 5 carbon atoms in total, for example, trifluoromethyl and difluoromethyl radicals; and acyl radicals, more preferably acyl radicals having up to 8 carbon atoms in total, for example, acetyl, propionyl, benzoyl and benzenesulfonyl radicals.

Examples of the nitrogenous heterocyclic ring formed by Z₁₁ or Z₁₂ include thiazoline, 4-methylthiazoline, thiazole, 4-methylthiazole, 4,5-dimethylthiazole, 4-phenylthiazole, benzothiazole, 5-methylbenzothiazole, 6-methylbenzothiazole, 5-ethylbenzothiazole, 5,6-dimethylbenzothiazole, 5-methoxybenzothiazole, 6-methoxybenzothiazole, 5-butoxybenzothiazole, 5,6-dimethoxybenzothiazole, 5-methoxy-6-methylbenzothiazole, 5-chlorobenzothiazole, 5-chloro-6-methylbenzothiazole, 5-phenylbenzothiazole, 5-acetylaminobenzothiazole, 6-propionylaminobenzothiazole, 5-hydroxybenzothiazole, 5-hydroxy-6-methylbenzothiazole, 5-ethoxycarbonylbenzothiazole, 5-carboxybenzothiazole, naphtho[1,2-d]thiazole, naphtho[2,1-d]thiazole, 5-methyInaphtho[1,2-d]thiazole, 8-methoxynaphtho[1,2-d]thiazole, 8,9-dihydronaphthothiazole, 3,3-diethylindolenine, 3,3-dipropylindolenine, 3,3-dimethylindolenine, 3,3,5-trimethylindolenine, selenazoline, selenazole, benzoselenazole, 5-methylbenzoselenazole, 6-methylbenzoselenazole, 5-methoxybenzoselenazole, 6-methoxybenzoselenazole, 5-chlorobenzoselenazole, 5,6-dimethylbenzoselenazole, 5-hydroxybenzoselenazole, 5-hydroxy-6-methylbenzoselenazole, 5,6-dimethoxybenzoselenazole, 5-ethoxycarbonylbenzoselenazole, naphtho[1,2-d]selenazole, naphtho[2,1-d]selenazole, oxazole, 4-methyloxazole, 4,5-dimethyloxazole, 4-phenyloxazole, benzoxazole, 5-hydroxybenzoxazole, 5-methoxybenzoxazole, 5-phenylbenzoxazole, 5-phenethylbenzoxazole, 5-phenoxybenzoxazole, 5-chlorobenzoxazole, 5-chloro-6-methylbenzoxazole, 5-phenylthiobenzoxazole, 6-ethoxy-5-hydroxybenzoxazole, 6-methoxybenzoxazole, naphtho[1,2-d]oxazole, naphtho[2,1-d]oxazole, naphtho[2,3-d]oxazole, 1-ethyl-5-cyanobenzimidazole, 1-ethyl-5-chlorobenzimidazole, 1-ethyl-5,6-dichlorobenzimidazole, 1-ethyl-6-chloro-5-cyanobenzimidazole, 1-ethyl-6-chloro-5-trifluoromethylbenzimidazole, 1-propyl-5-butoxycarbonylbenzimidazole, 1-benzyl-5-methylsulfonylbenzimidazole, 1-allyl-5-chloro-6-acetylbenzimidazole, 1-ethylnaphtho[1,2-d]imidazole, 1-ethyl-6-chloronaphtho[2,3-d]imidazole, 2-quinoline, 4-quinoline, 8-fluoro-4-quinoline, 6-methyl-2-quinoline, 6-hydroxy-2-quinoline, and 6-methoxy-2-quinoline.

R₁₁ and R₁₂, which may be identical or different, each represent a substituted or unsubstituted alkyl or alkenyl radical having up to 10 carbon atoms in total. Preferred substituents on the alkyl and alkenyl radicals include sulfo, carboxy, halogen atom, hydroxy, alkoxy radicals having up to 6 carbon atoms, substituted or unsubstituted aryl radicals having up to 8 carbon atoms (e.g., phenyl, tolyl, sulfophenyl and carboxyphenyl radicals), heterocyclic radicals (e.g., furyl and thienyl radicals), substituted or unsubstituted aryloxy radicals having up to 8 carbon atoms (e.g., chlorophenoxy, phenoxy, sulfophenoxy and hydroxyphenoxy radicals), acyl radicals having up to 8 carbon atoms (e.g., benzenesulfonyl, methanesulfonyl, acetyl and propionyl radicals), alkoxycarbonyl radicals having up to 6 carbon atoms (e.g., ethoxycarbonyl and butoxycarbonyl radicals), cyano radicals, alkylthio radicals having up to 6 carbon atoms (e.g., methylthio and ethylthio radicals), substituted or unsubstituted arylthio radicals having up to 8 carbon atoms (e.g., phenylthio and tolylthio radicals), substituted or unsubstituted carbamoyl radicals having up to 8 carbon atoms (e.g., carbamoyl and N-ethylcarbamoyl radicals), and acylamino radicals having up to 8 carbon atoms (e.g., acetylamino and methanesulfonylamino radicals). When substituted, these radicals may have one or more substituents.

Examples of the radical represented by R₁₁ and R₁₂ include methyl, ethyl, propyl, allyl, pentyl, hexyl, methoxyethyl, ethoxyethyl, phenethyl, tolylethyl, sulfophenethyl, 2,2,2-trifluoroethyl, 2,2,3,3-tetrafluoropropyl, carbamoylethyl, hydroxyethyl, 2-(2-hydroxyethoxy)ethyl, carboxymethyl, carboxyethyl, ethoxycarbonylmethyl, sulfoethyl, 2-chloro-3-sulfopropyl, 3-sulfopropyl, 2-hydroxy-3-sulfopropyl, 3-sulfobutyl, 4-sulfobutyl, 2-(2,3-dihydroxypropyloxy)ethyl, and 2-[2-(3-sulfopropyloxy)ethoxy]ethyl radicals.

Each of R₁₃ and R₁₅ represents a hydrogen atom, or R₁₃ and R₁₁ taken together and R₁₅ and R₁₂ taken together may form a five or six-membered ring.

R₁₄ is a hydrogen atom or a lower alkyl radical which may have a substituent, for example, methyl, ethyl, propyl, methoxyethyl, and phenethyl radicals, with alkyl radicals having up to 5 carbon atoms being preferred.

X₁₁ is an acid anion residue, for example, a chloride ion, bromide ion, iodide ion, perchlorate ion, rhodanate ion and p-toluenesulfonate ion.

Letter v is equal to 0 or 1, and v = 0 in the case of an internal salt.

Preferred among the sensitizing dyes of formula (9) are those dyes of the formula wherein u is 1, Z₁₁ is a group of atoms forming a heterocyclic nucleus such as oxazole, benzoxazole, and naphthoxazole, Z₁₂ is a group of atoms forming a heterocyclic nucleus such as benzimidazole and naphthoimidazole, at least one of R₁₁ and R₁₂ is a radical having a sulfo, carboxy or hydroxy radical, and R₁₄ is a hydrogen atom. As previously described, the heterocyclic nucleus represented by each of Z₁₁ and Z₁₂ may have one or more substituents thereon which are preferably electron attracting substituents when Z₁₂ forms a benzimidazole or naphthoimidazole nucleus.

More preferred among the sensitizing dyes of formula (9) are those dyes of the formula wherein u is 1, Z₁₁ is a group of atoms forming a benzoxazole nucleus, Z₁₂ is a group of atoms forming a benzimidazole nucleus, at least one of R₁₁ and R₁₂ is a radical having a sulfo or carboxy radical, and R₁₄ is a hydrogen atom. As previously described, the heterocyclic nucleus represented by each of Z₁₁ and Z₁₂ may have one or more substituents thereon. For the benzimidazole nucleus, such substituents are preferably selected from a chlorine atom, fluorine atom, cyano radical, alkoxycarbonyl radicals having up to 5 carbon atoms in total, acyl radicals having up to 7 carbon atoms in total, and perfluoroalkyl radicals having up to 4 carbon atoms (e.g., trifluoromethyl radical). For the other heterocyclic nuclei, such substituents are preferably selected from substituted or unsubstituted phenyl radicals having up to 8 carbon atoms, alkyl radicals having up to 5 carbon atoms, alkoxy radicals having up to 5 carbon atoms, acylamino radicals having up to 5 carbon atoms in total, carboxy radicals, alkoxycarbonyl radicals having up to 5 carbon atoms in total, benzyl radical, phenethyl radical, and chlorine atom.

Illustrative, non-limiting examples of the compound of formula (9) are given below.

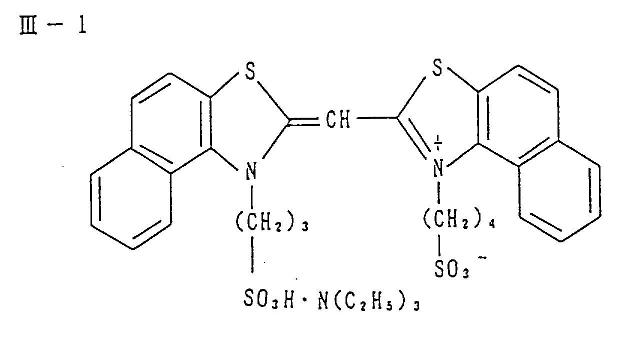

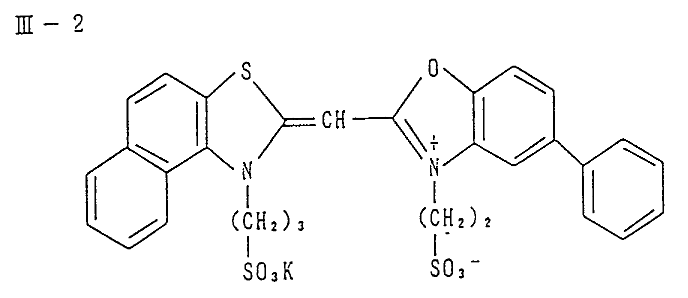

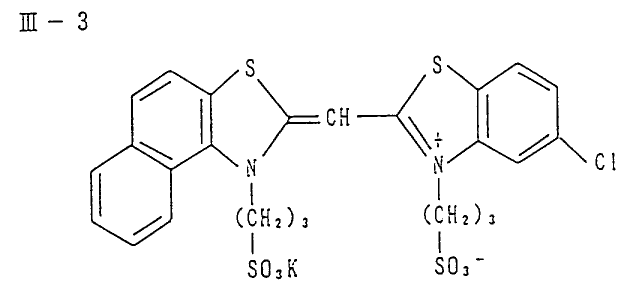

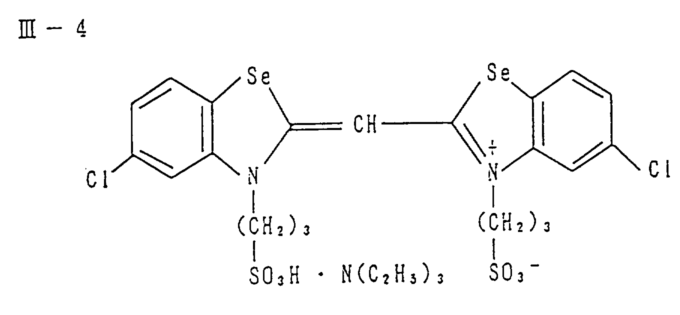

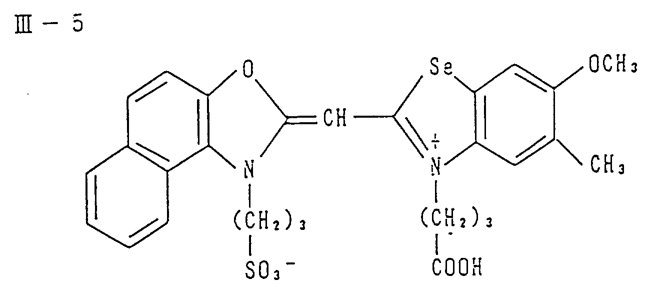

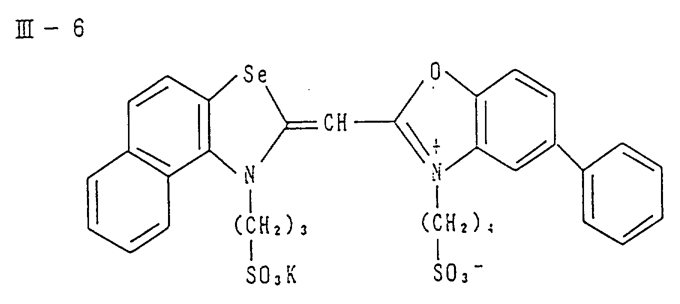

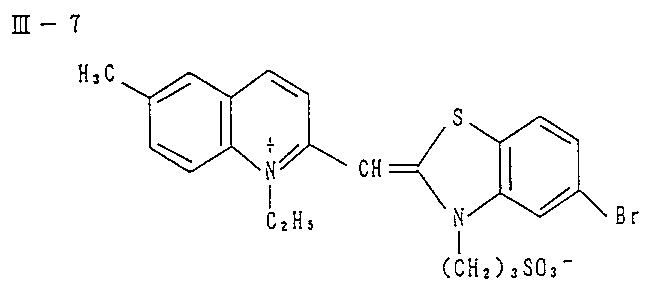

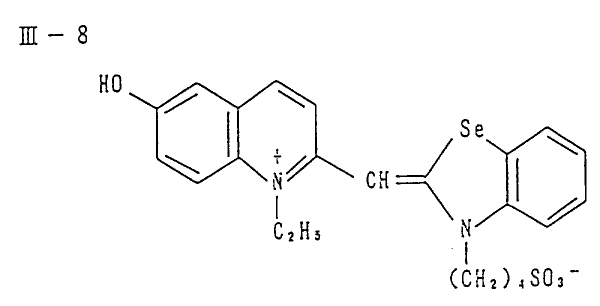

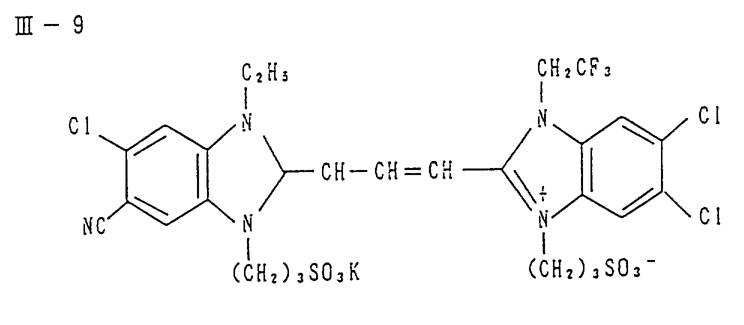

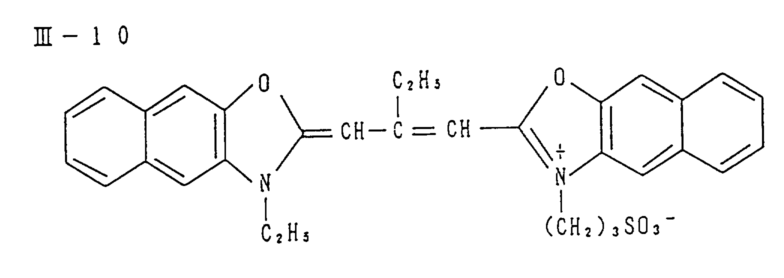

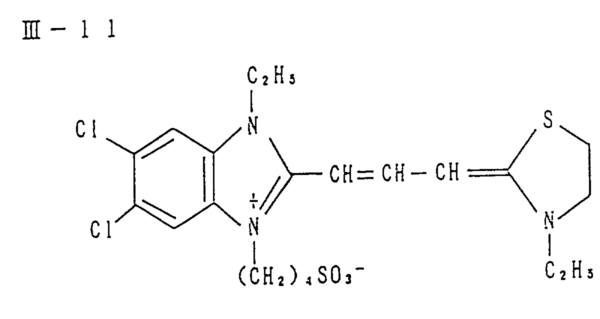

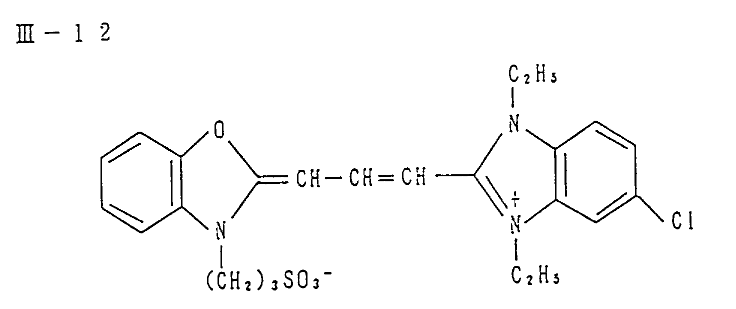

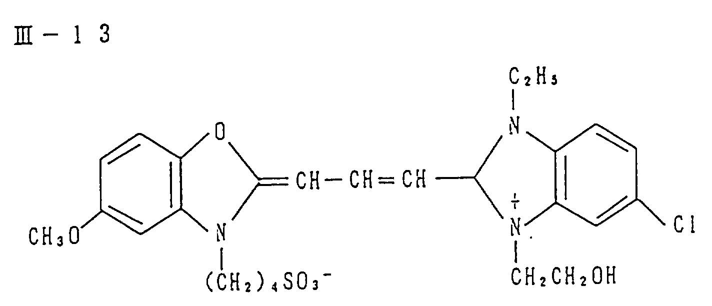

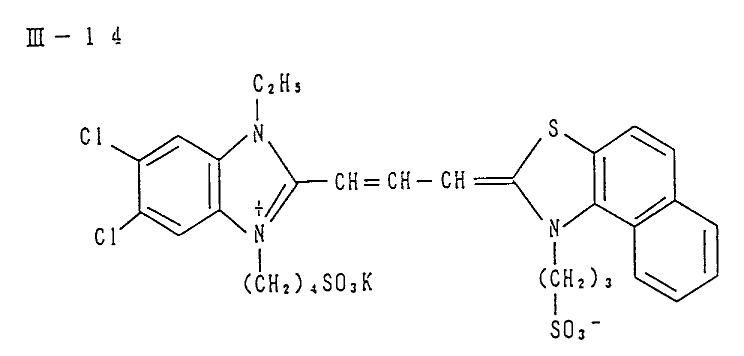

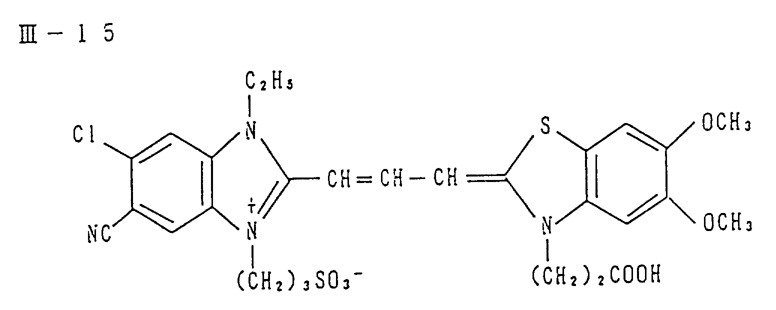

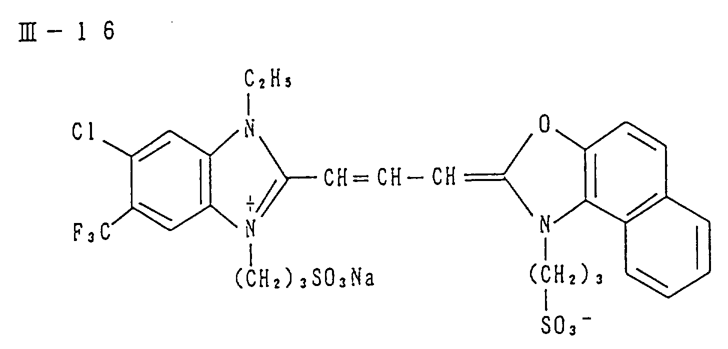

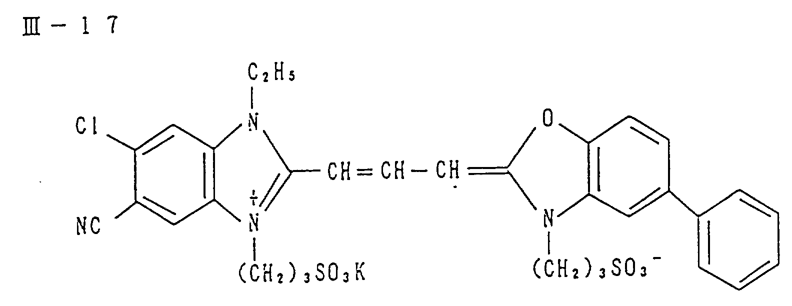

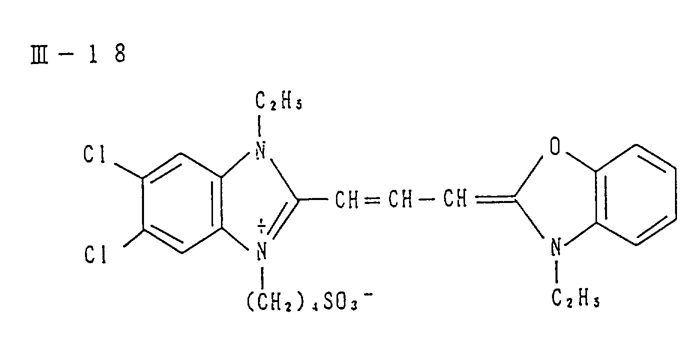

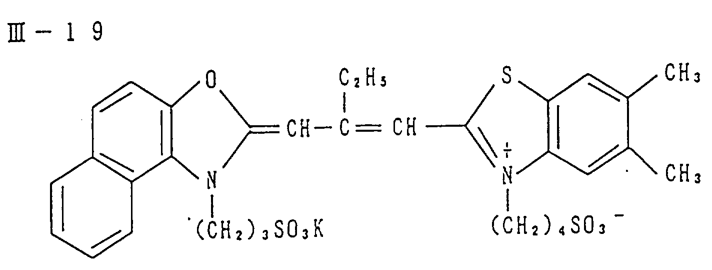

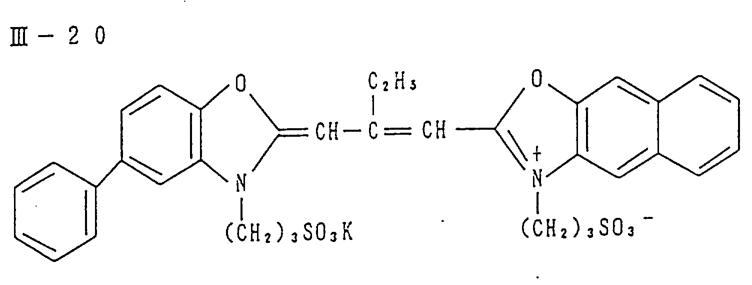

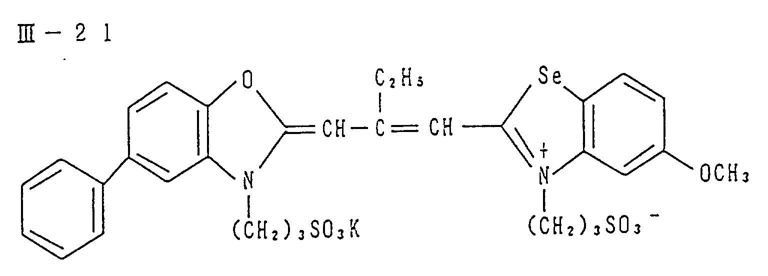

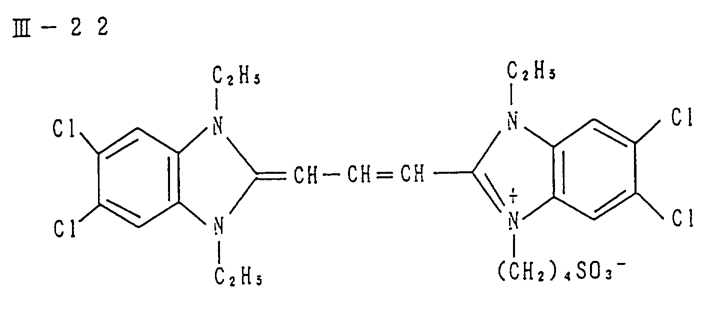

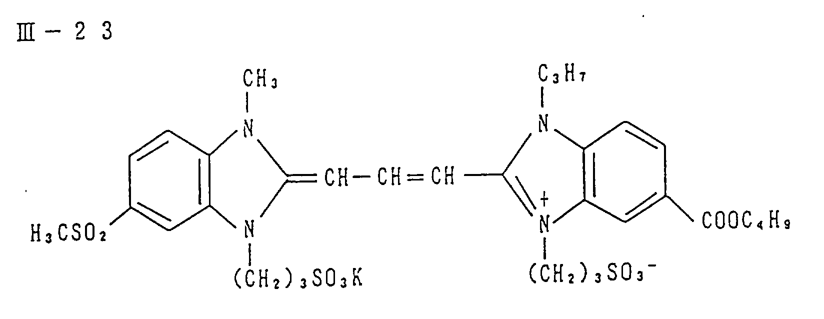

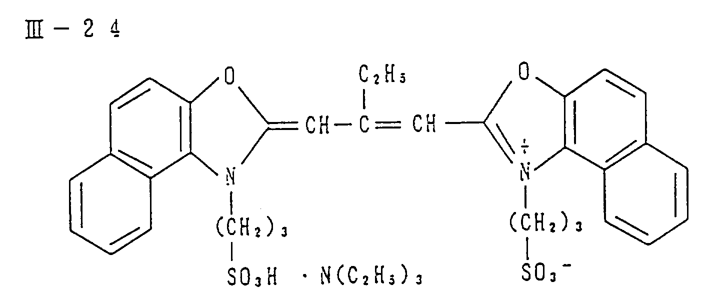

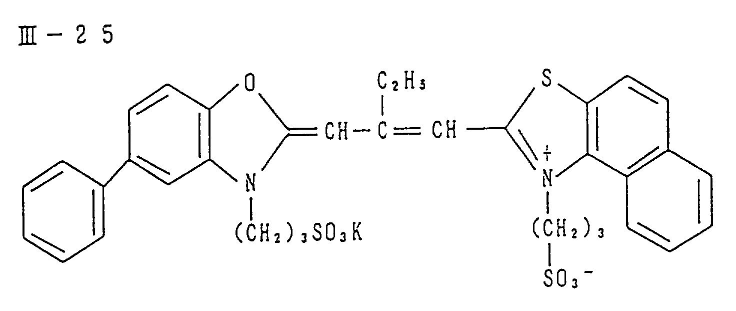

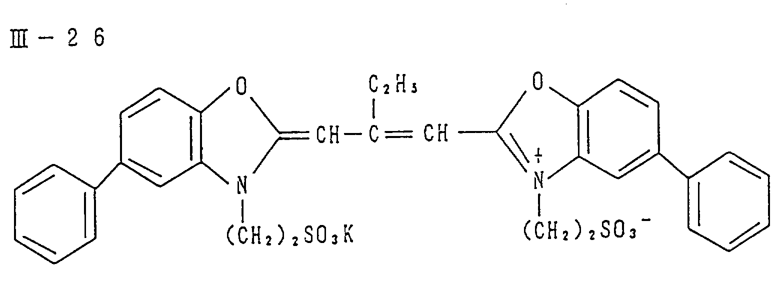

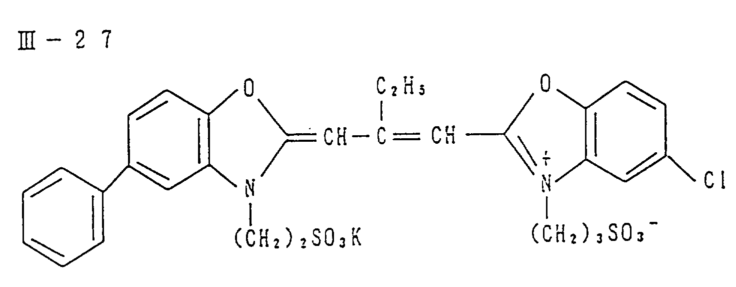

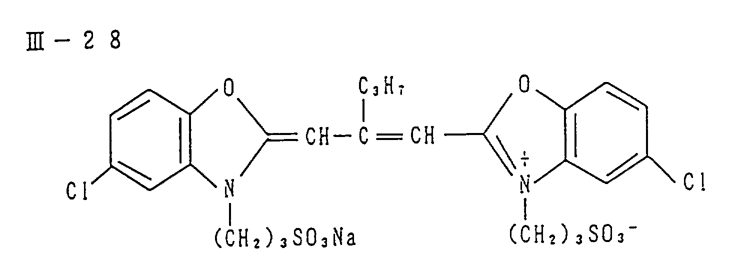

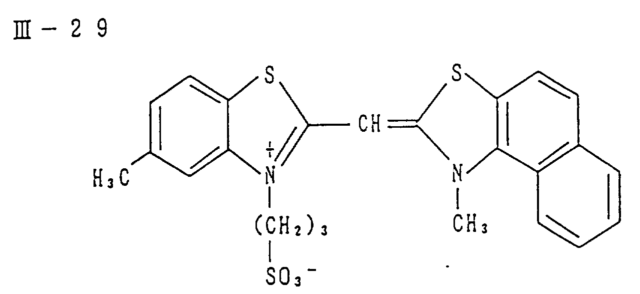

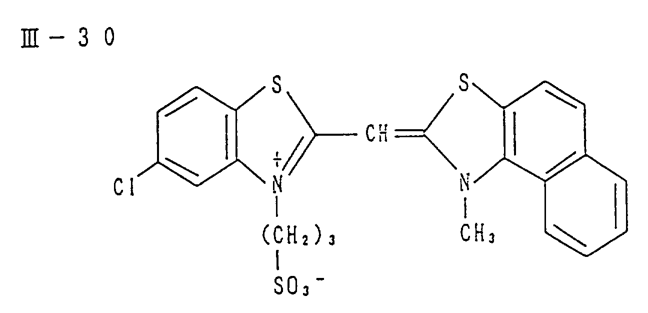

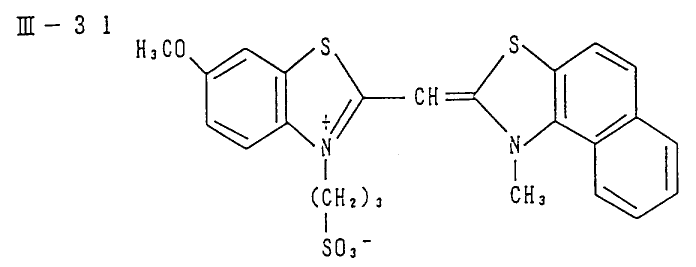

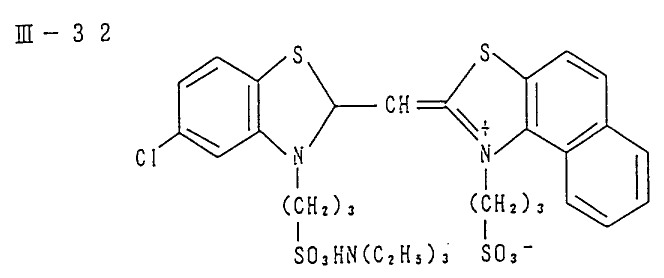

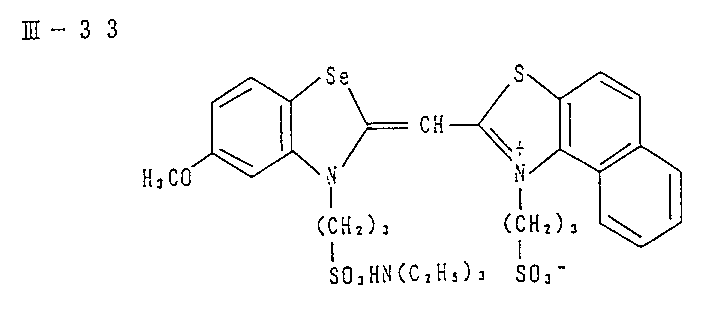

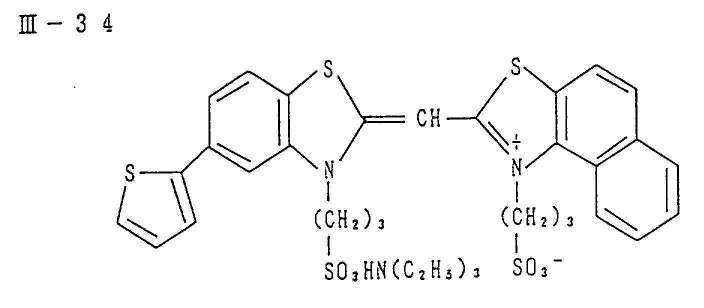

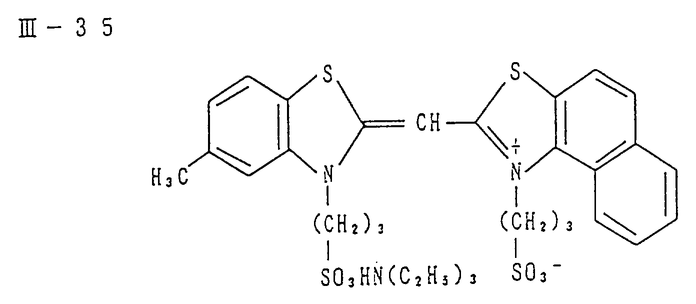

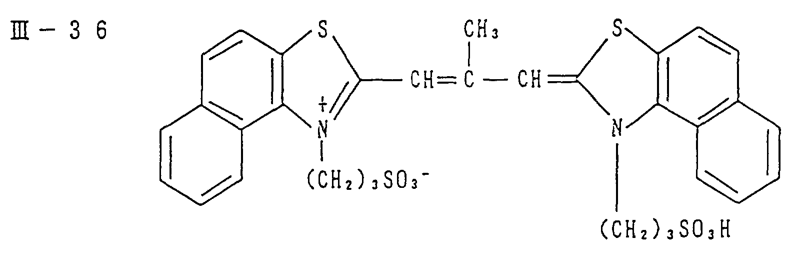

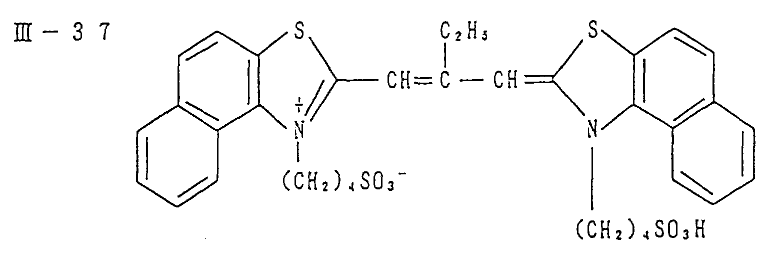

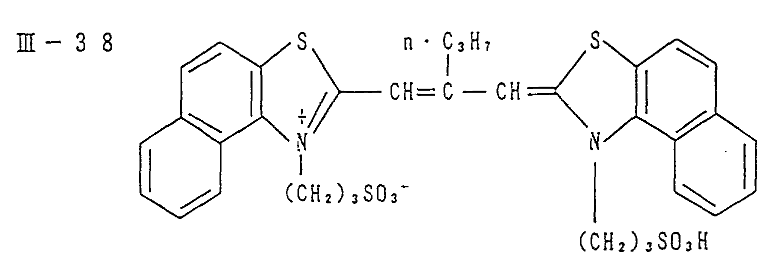

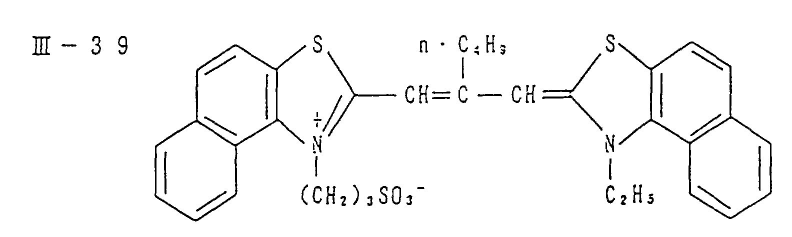

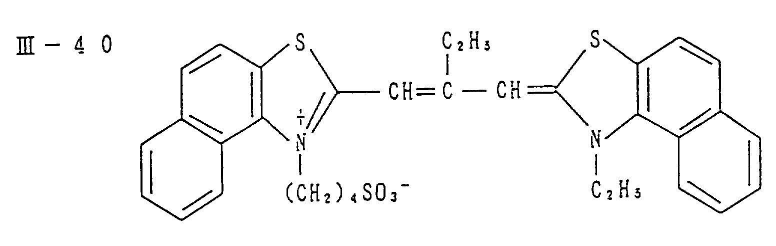

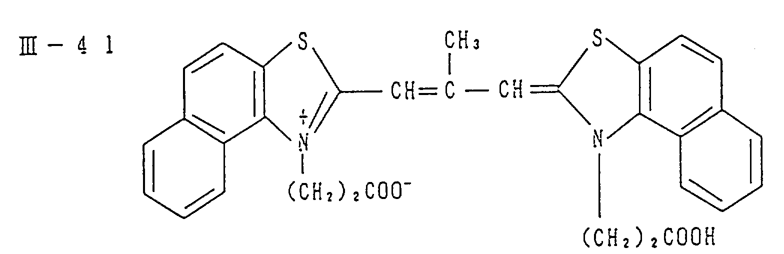

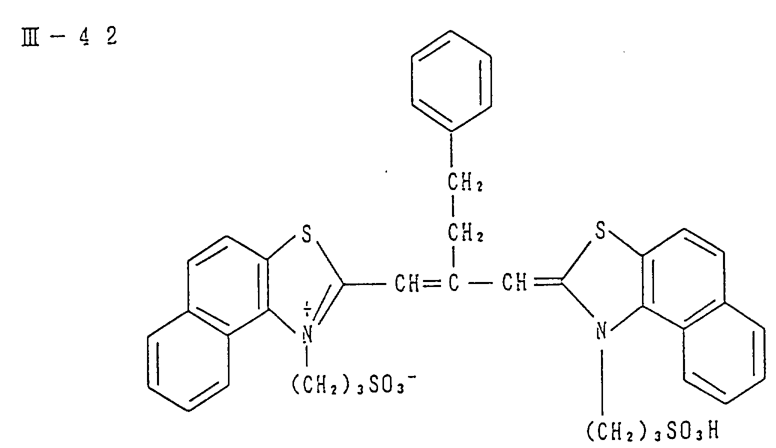

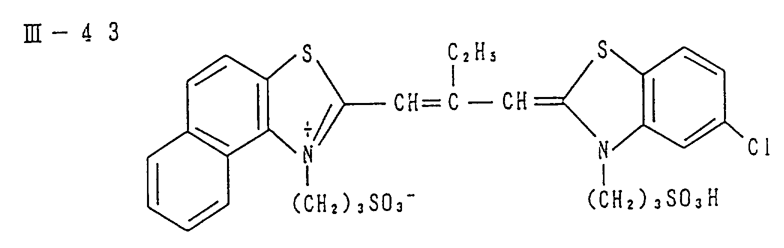

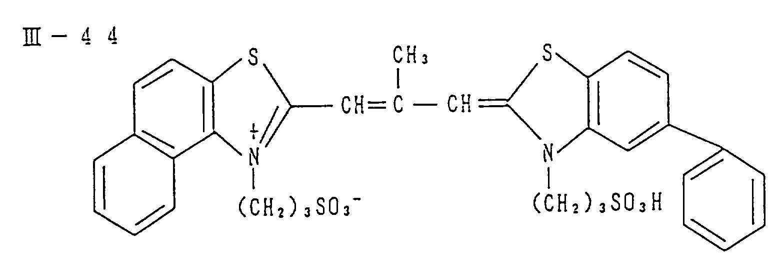

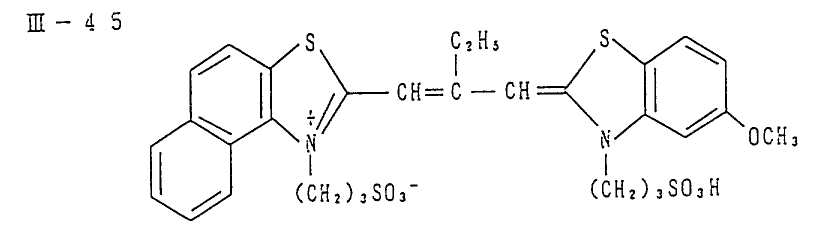

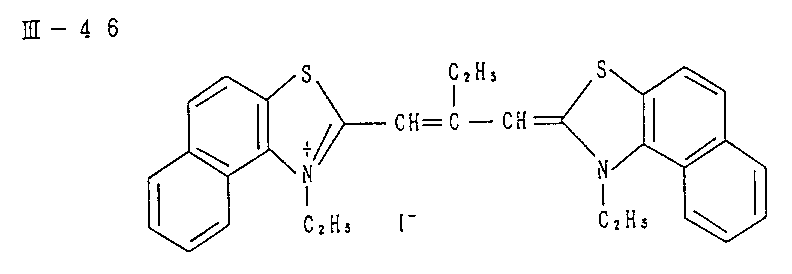

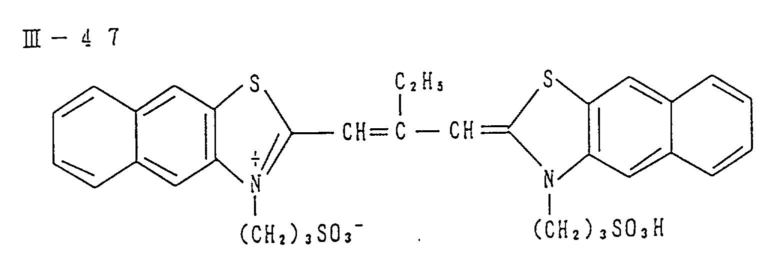

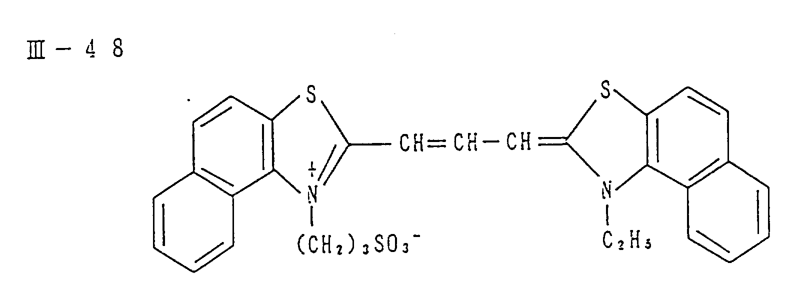

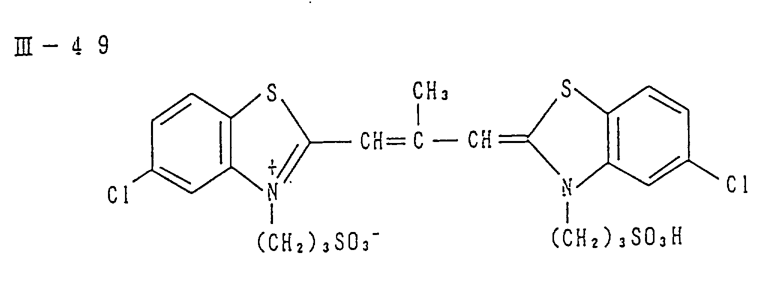

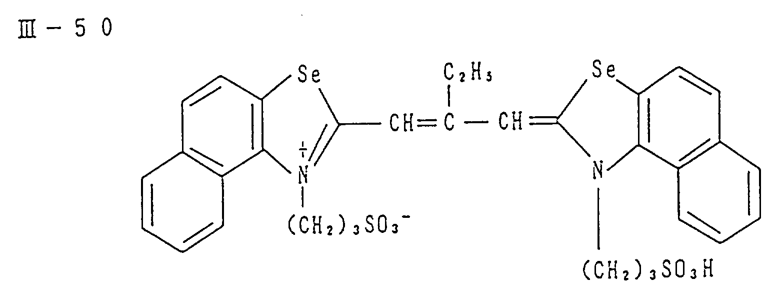

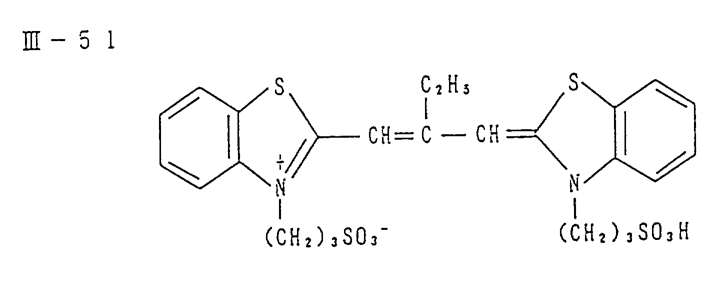

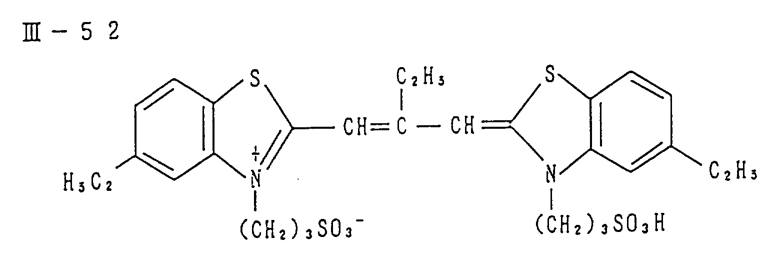

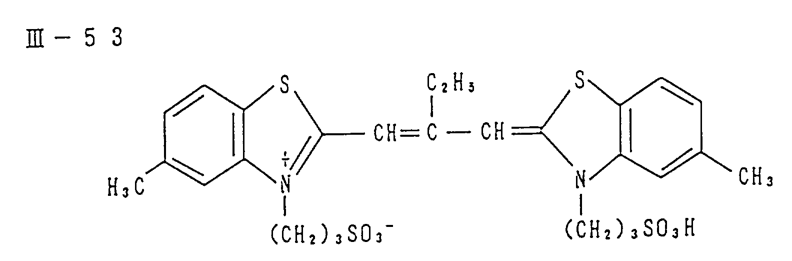

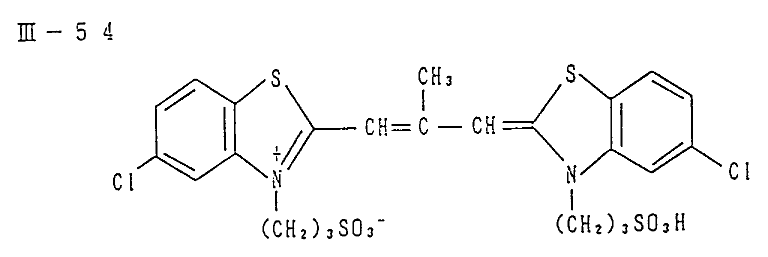

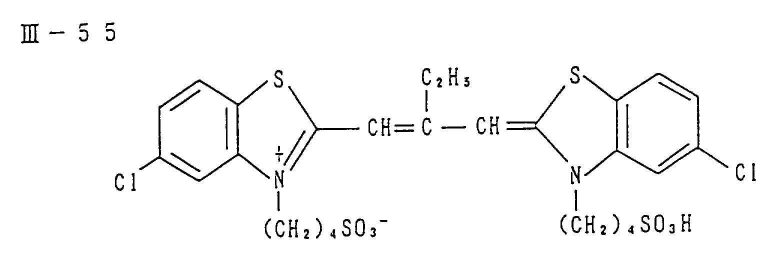

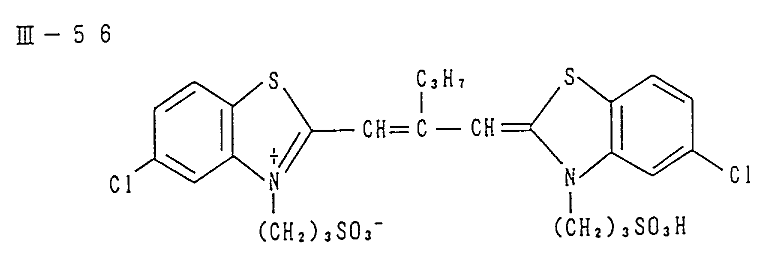

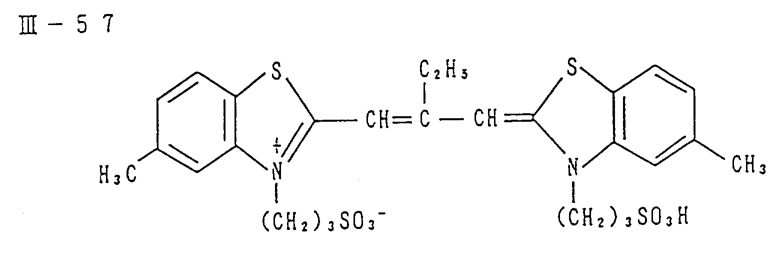

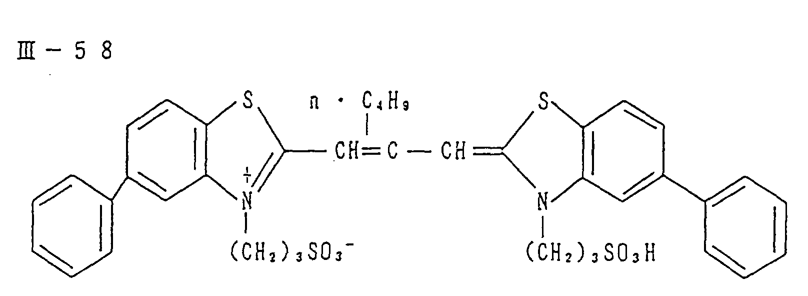

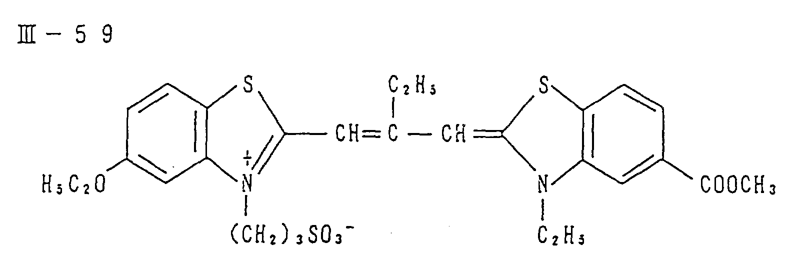

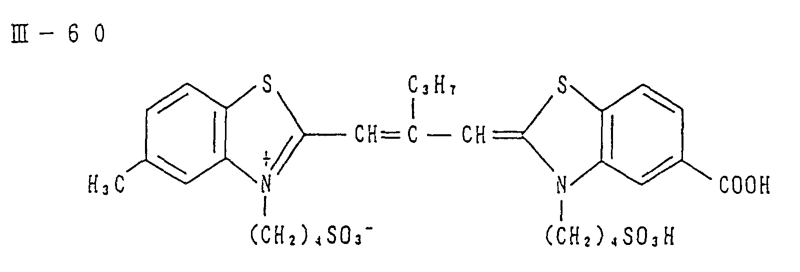

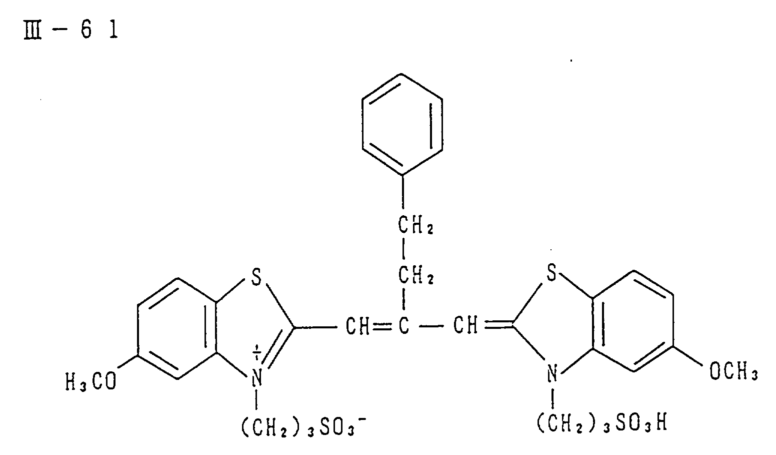

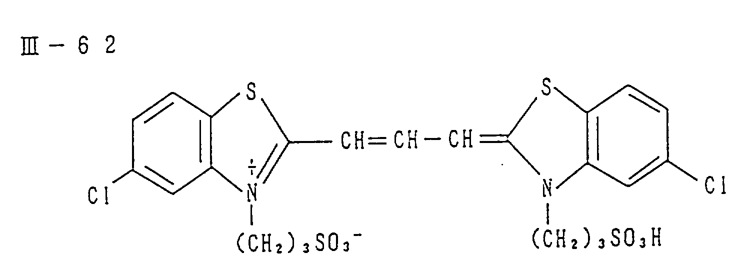

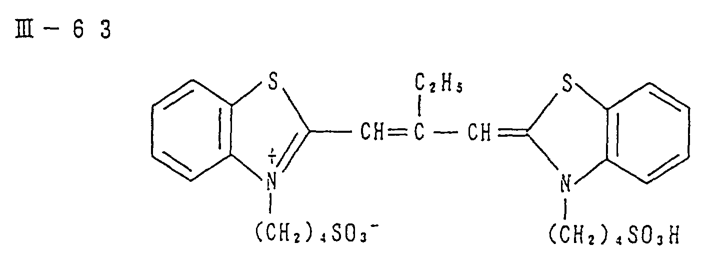

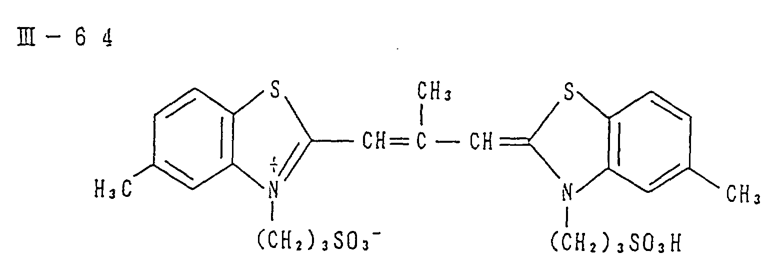

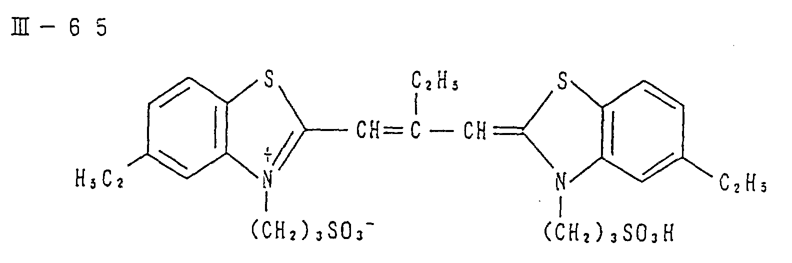

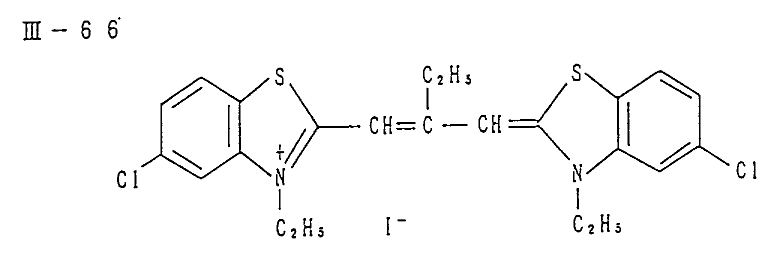

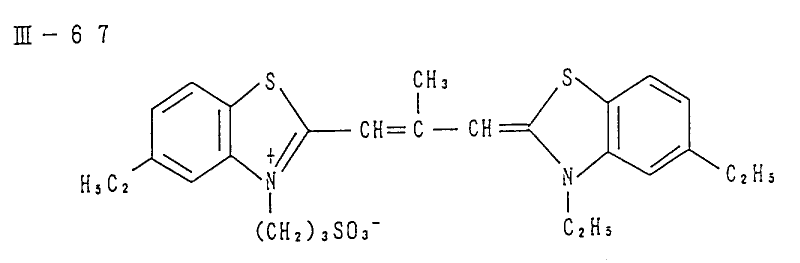

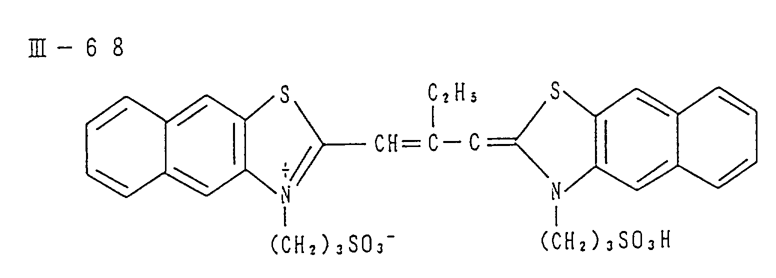

In formula (10), X₁ and X₂, which may be identical or different, each represent an oxygen atom, sulfur atom, selenium atom, a radical of the formula: >N-R₇ wherein R₇ is an alkyl radical or a radical of the formula: 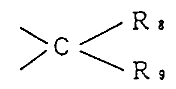 wherein R₈ and R₉ are alkyl radicals. Z₁ and Z₂, which may be identical or different, each represent a group of atoms necessary to form a five-membered nitrogenous heterocyclic ring. R₂ and R₂, which may be identical or different, each represent an alkyl or alkenyl radical. R₃ is an alkyl, alkenyl or aryl radical. R₄, R₅ and R₆, which may be identical or different, each represent a hydrogen atom, halogen atom, alkyl radical or aryl radical. Y₁ represents a sulfur atom, an oxygen atom or a radical of the formula: >N-R₁₀ wherein R₁₀ is an alkyl radical. Q₁ is a group of atoms necessary to form a five or six-membered ring by connecting to the carbon atoms of the methylene linkage. X₃ is an acid anion. Letters p, q and r each are equal to 1 or 2.

Examples of the nitrogenous heterocyclic ring formed by Z₁ or Z₂ include thiazole, benzothiazole, naphtho[1,2-d]-thiazole, naphtho[2,1-d]thiazole, naphtho[2,3-d]thiazole, selenazole, benzoselenazole, naphtho[2,1-d]selenazole, naphtho[1,2-d]selenazole, oxazole, benzoxazole, naphtho[1,2-d]oxazole, [2,1-d]oxazole, naphtho[2,3-d]oxazole, 3,3-dialkylindolenine, imidazole, benzimidazole, and naphtho[1,2-d]imidazole. These heterocyclic rings may have one or more substituents, for example, alkyl radicals (e.g., methyl, ethyl, butyl and trifluoromethyl radicals), aryl radicals (e.g., phenyl and tolyl radicals), hydroxy radicals, alkoxy radicals (e.g., methoxy, ethoxy, and butoxy radicals), carboxy radicals, alkoxycarbonyl radicals (e.g., methoxycarbonyl and ethoxycarbonyl radicals), halogen atoms (e.g., fluorine, chlorine, bromine and iodine), aralkyl radicals (e.g., benzyl and phenethyl radicals), cyano radical, and alkenyl radicals (e.g., allyl radicals).

Examples of the alkyl radical represented by R₁ and R₂ include lower alkyl radicals such as methyl, ethyl, propyl and butyl; hydroxyalkyl radicals such as β-hydroxyethyl and γ-hydroxypropyl; alkoxyalkyl radicals such as β-methoxyethyl and γ-methoxypropyl; acyloxyalkyl radicals such as β-acetoxyethyl, γ-acetoxypropyl and β-benzoyloxyethyl; carboxyalkyl radicals such as carboxymethyl and β-carboxyethyl; alkoxycarbonylalkyl radicals such as methoxycarbonylmethyl, ethoxycarbonylethyl and β-ethoxycarbonylethyl; sulfoalkyl radicals such as β-sulfoethyl, γ-sulfopropyl and δ-sulfobutyl; and aralkyl radicals such as benzyl, phenethyl and sulfobenzyl. An exemplary alkenyl radical is an allyl radical.

Exemplary radicals represented by R₃ are alkyl and alkenyl radicals as described just above for R₁ and R₂ as well as aryl radicals such as phenyl, tolyl, methoxyphenyl, chlorophenyl and naphthyl radicals.

R₄ to R₆ represent hydrogen atoms, alkyl and aryl radicals as described just above, and halogen atoms such as fluorine, chlorine, bromine and iodine. The alkyl radicals represented by R₇ to R₁₀ are preferably lower alkyl radicals such as methyl and ethyl. The ring represented by Q₁ may have a lower alkyl substituent such as methyl.

X₃ is an acid anion, for example, an alkyl sulfate ion (e.g., methyl sulfate and ethyl sulfate), thiocyanate ion, toluenesulfonate ion, a halide ion (e.g., a chloride, bromide, and iodide ion), and a perchlorate ion, but is absent where the dye has a betain analogous structure.

Illustrative, non-limiting examples of the sensitizing dye of formula (10) are given below as sensitizing dyes IV-1 to IV-13.

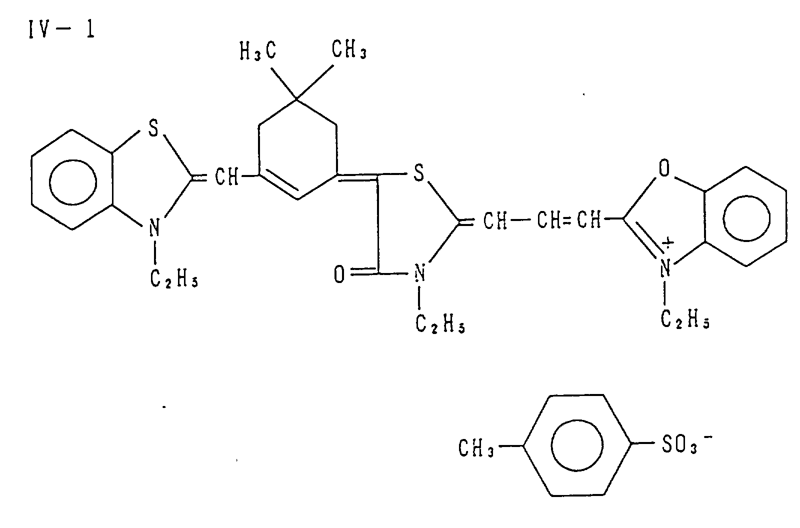

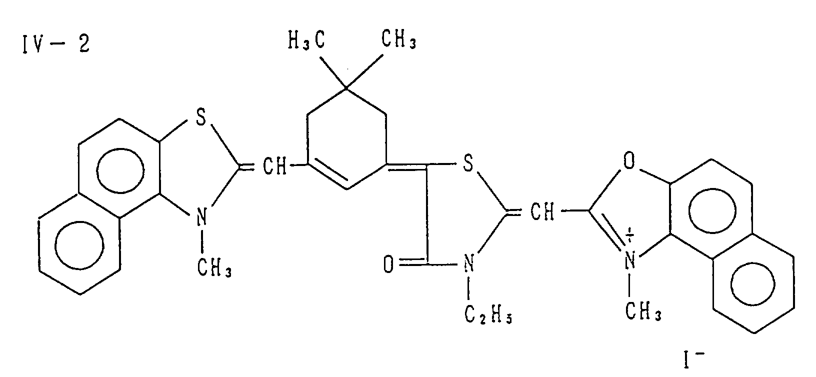

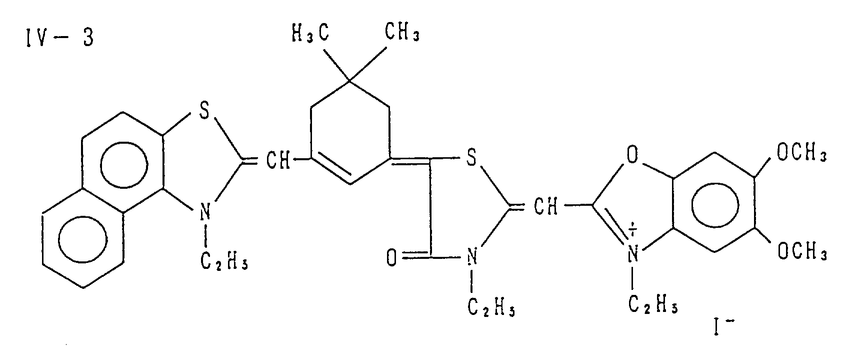

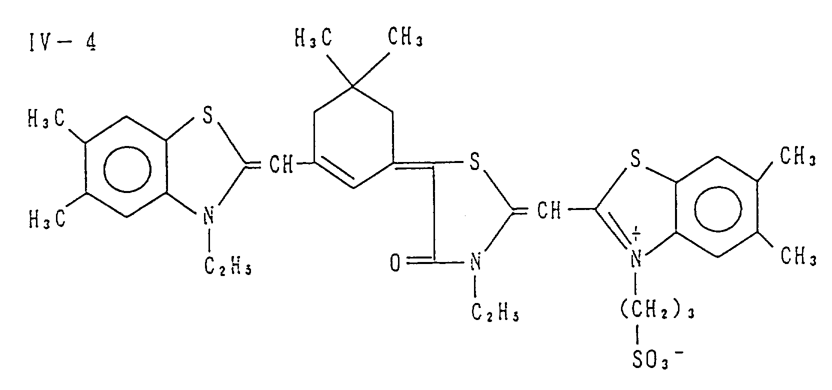

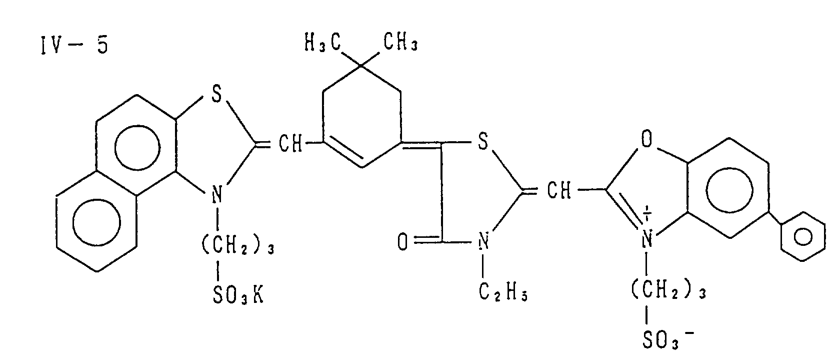

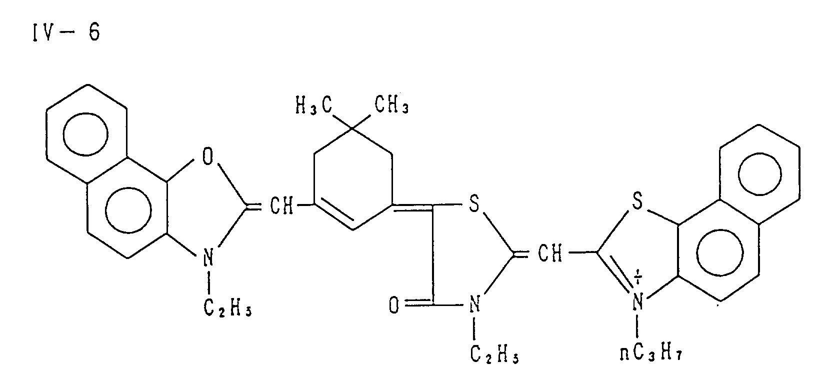

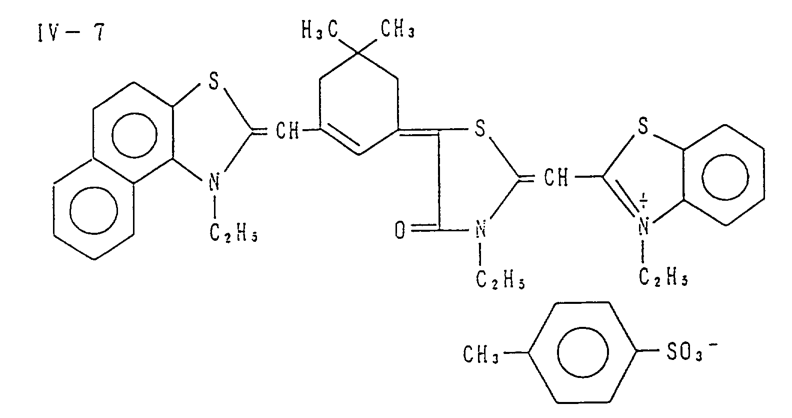

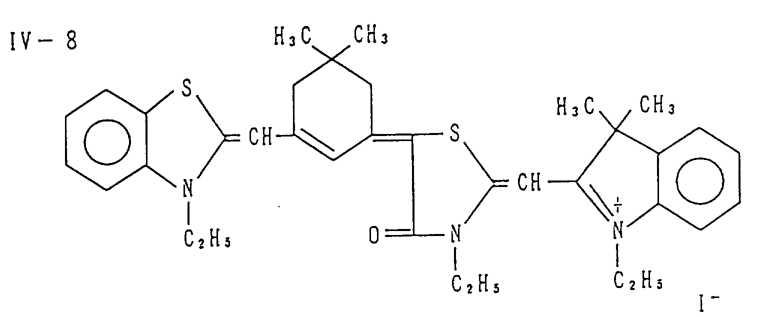

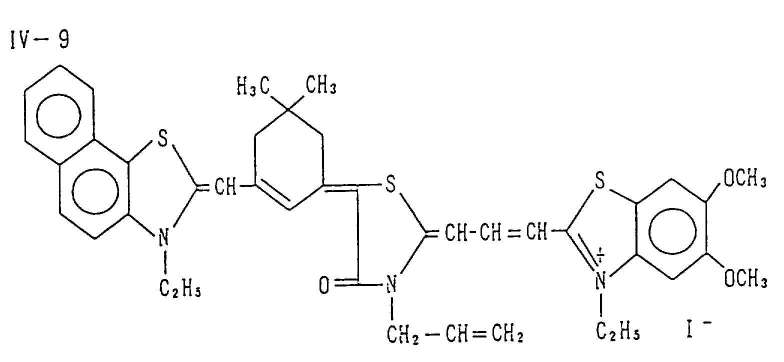

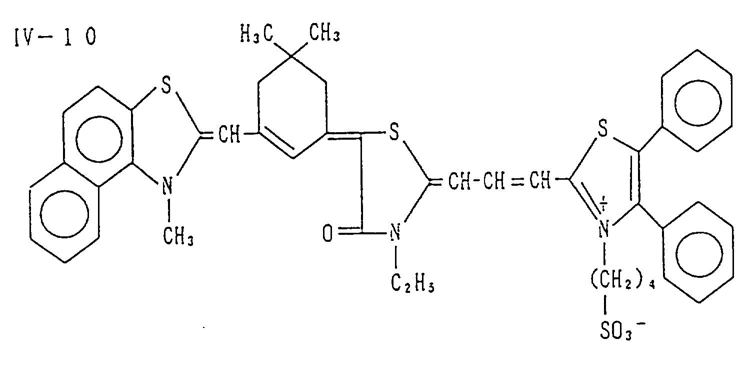

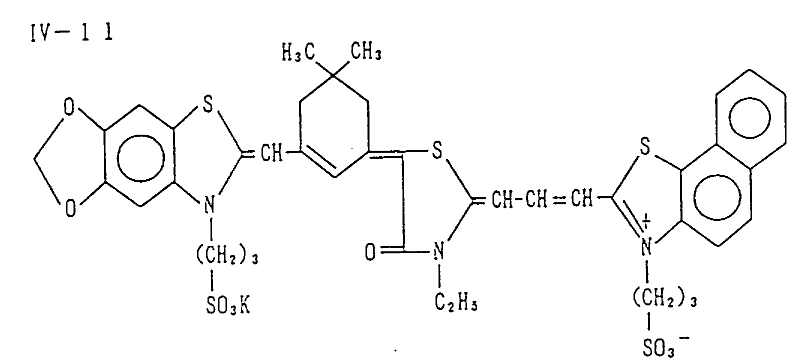

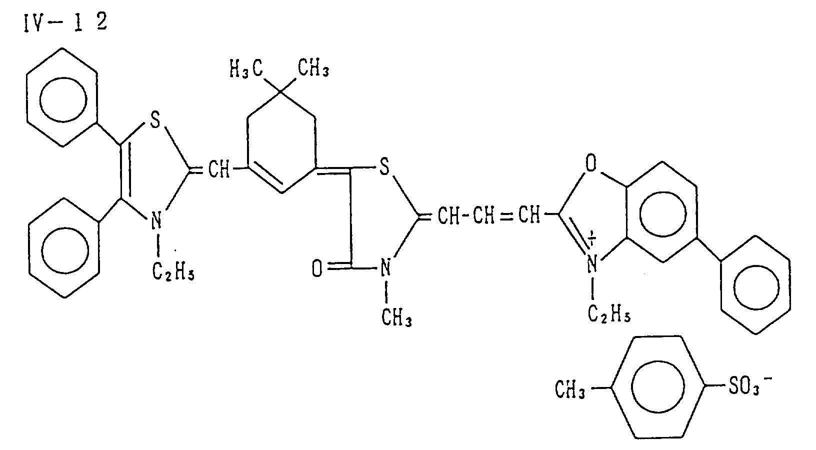

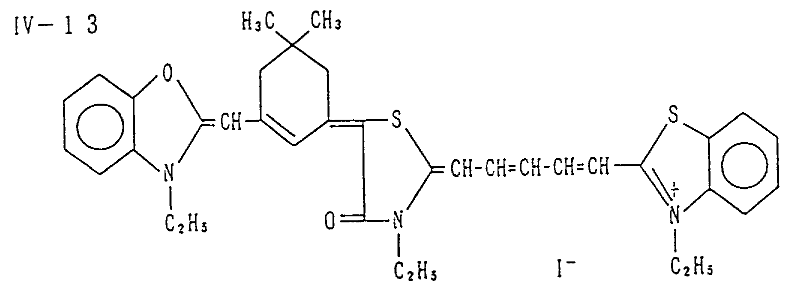

Also useful are the sensitizing dyes described in Japanese Patent Application No. 351620/1992.

The sensitizing dyes used herein may be synthesized by commonly known techniques. The sensitizing dye may be added to a silver halide emulsion at any stage before the emulsion is coated. The sensitizing dye may be added in a varying amount although the preferred amount is from 1x10⁻⁵ to 1x10⁻² mol per mol of silver halide.

In the emulsion layer or another hydrophilic colloidal layer, water-soluble dyes may be contained as the filter dye or for anti-irradiation or other purposes. Preferred filter dyes include dyes for further reducing photographic sensitivity and dyes having substantial light absorption in the range of 330 to 800 nm for increasing safety against safe light. In accordance with their purpose, these dyes are preferably added to a silver halide emulsion layer or they are added above a silver halide emulsion layer, that is, to a non-photosensitive hydrophilic colloid layer disposed remote from the silver halide emulsion with respect to the support together with a mordant in a fixed manner. They are generally added in amounts of 10⁻² g/m² to 1 g/m², preferably 50 mg/m² to 500 mg/m² depending on the molar extinction coefficient thereof. Exemplary dyes are described in JP-A 064039/1988.

In the practice of the invention, various other compounds can be added to lithographic printing material for the purposes of preventing fogging and stabilizing photographic performance during preparation, storage or processing of the lithographic printing material. Such additives include azoles, for example, benzothiazolium salts, nitroindazoles, chlorobenzimidazoles, bromobenzimidazoles, mercaptothiazoles, mercaptobenzothiazoles, mercaptothiadiazoles, aminotriazoles, benzothiazoles, and nitrobenzotriazoles; mercaptopyrimidines; mercaptotriazines; thioketo compounds such as oxazolinethion; azaindenes such as triazaindenes, tetraazaindenes (e.g., 4-hydroxy substituted-1,3,3a,7-tetraazaindenes), and pentaazaindenes; benzenethiosulfonic acid, benzenesulfinic acid, and benzenesulfonic amide, which are known as antifoggants or stabilizers.

The lithographic printing material of the invention includes an emulsion layer to which may be added an agent for providing increased sensitivity, increased contrast, or accelerated development. Such agents include polyalkylene oxides or derivatives thereof such as ethers, esters and amines, thioether compounds, thiomorpholine compounds, quaternary ammonium salt compounds, urethane derivatives, urea derivatives, imidazole derivatives, and developing agents such as dihydroxybenzenes and 3-pyrazolidones. Preferred among others are dihydroxybenzenes such as hydroquinone, 2-methylhydroquinone and catechol and 3-pyrazolidones such as 1-phenyl-3-pyrazolidone and 1-phenyl-4-methyl-4-hydroxymethyl-3-pyrazolidone. They are generally used in a coverage of less than 5 g/m². Preferably the dihydroxybenzenes are used in a coverage of 0.01 to 2.5 g/m² while the pyrazolidones are used in a coverage of 0.01 to 0.5 g/m².

The lithographic printing material of the present invention is generally in the form of a silver salt offset printing material of a basic layer structure including an anti-halation layer as a undercoat on a support, a photosensitive silver halide emulsion layer on the undercoat, and a physical development nucleus layer on the emulsion layer. An intermediate layer may be interposed between any two adjacent layers. Preferably, the printing material of the invention has a physical development nucleus layer disposed directly on a photosensitive silver halide emulsion layer.

The anti-halation layer disposed nearest to the support is a hydrophilic colloid layer having carbon black dye or pigment dispersed therein. To impart printability to the anti-halation layer or emulsion layer, fine powder having a size of 1 to 10 µm such as silica may be added.

Included in the silver halide emulsion used herein is a hydrophilic binder which is generally gelatin. Also advantageously gelatin may be modified by partially or entirely replacing by synthetic polymers such as polyvinyl alcohol, poly-N-vinyl pyrrolidone, polyacrylic acid copolymers, and methyl vinyl ether/maleic anhydride copolymers or cellulose derivatives, gelatin derivatives or the like. Various other compounds can be added to the emulsion for the purposes of preventing fog during development and providing stabilization during preparation or storage as previously described.

In addition to the above-mentioned compounds, there may be used various other additives such as hardeners and surfactants. Exemplary compounds are described in Product Licensing Index, Vol. 92, No. 9232, pages 107-110, I-XIII, XVI-XVII and XXIII (December 1971).

The thus prepared emulsion is coated as a layer on the anti-halation layer by a commonly known technique to form a photosensitive silver halide emulsion layer according to the present invention.

Also included in the printing material is a physical development nucleus layer. Physical development nuclei may be provided by reducing water-soluble salts of noble metals such as gold, silver, platinum and palladium or heavy metals such as zinc, lead, cadmium, nickel, cobalt, iron, chromium, tin, antimony and bismuth to form metal colloids, or by mixing water-soluble salts of such metals, for example, nitrates, acetates, borates, chlorides and hydroxides with water-soluble sulfides such as sodium sulfide.

A hydrophilic binder is used in the physical development nucleus layer. Useful binders are the same hydrophilic polymers as previously described for the photosensitive silver halide emulsion layer, with gelatin, polyvinyl alcohol or methyl vinyl ether/maleic anhydride copolymers or mixtures thereof being preferred. The amount of the hydrophilic binder used ranges from 30% to 100% based on the weight of the physical development nuclei although it varies with a particular type of noble metal or binder.

Preferably the physical development nucleus layer is coated directly on the photosensitive silver halide emulsion layer.

The support for the offset printing material of the invention includes all types of support commonly used in the art, for example, nitrate film, cellulose acetate film, cellulose acetate butyrate film, polystyrene film, polyethylene phthalate film, polycarbonate film, and laminates thereof, as well as paper. Also useful are baryta and paper coated or laminated with α-olefin polymers, especially polymers of α-olefins having 2 to 10 carbon atoms such as polyethylene, polypropylene, and ethylene-butylene copolymers. The supports may be modified by the surface roughening method for providing enhanced bond to other polymers as described in JP-B 19068/1972 or the surface roughening method of JP-B 135840/1981. Another useful support is paper laminated with metal foil such as aluminum foil for minimizing plate elongation.

Colloidal silica may be used in a coating applied to the polyolefin surface for the purposes of improving adhesion to the polyolefin coated surface or improving printability. In this regard, reference is made to US Patent No. 3,161,519.

To enhance the bonding force between the support and a coating, the support on the surface may be pretreated by corona discharge treatment, ultraviolet exposure or flame treatment. With respect to the corona discharge treatment, reference is made to US Patent No. 2,018,189.

Hardening of the silver halide emulsion and/or other layers can be achieved by conventional techniques. Useful hardeners include aldehydes such as formaldehyde and glutaraldehyde; ketones such as diacetyl and cyclopentanedione; bis(2-chloroethylurea), 2-hydroxy-4,6-dichloro-1,3,5-triazine; compounds having reactive halogen as described in USP 3,288,775 and 2,732,303 and UKP 974,723 and 1,167,207; divinyl sulfone, 5-acetyl-1,3-diacryloylhexahydro-1,3,5-triazine; compounds having reactive olefin as described in USP 3,635,718, 3,232,763, 3,490,911 and 3,642,486 and UKP 994,869; N-hydroxymethylphthalimide; N-methylol compounds as described in USP 2,732,316 and 2,586,168; isocyanates as described in USP 3,103,437; aziridines as described in USP 3,017,280 and 2,983,611; acid derivatives as described in USP 2,725,294 and 2,725,295; carbodiimides as described in USP 3,100,704; epoxy compounds as described in USP 3,091,537; isooxazoles as described in USP 3,321,313 and 3,543,292; halogenocarboxyaldehydes such as mucochloric acid; and dioxane derivatives such as dihydroxydioxane and dichlorodioxane; as well as inorganic hardeners such as chromium alum and zirconium sulfate. Instead of the foregoing compounds, there may be used precursors, for example, alkali metal bisulfite aldehyde adducts, hydantoin methylol derivatives, and primary aliphatic nitroalcohols.

If desired, well-known surfactants may be added alone or in admixture to any of the layers of the offset printing material. The surfactants may be used as coating aids and as the case may be, used for other purposes, for example, emulsifying dispersion, development acceleration, improvement of photographic properties, electric charge row adjustment, and antistatic purposes.

Included in the surfactant are natural products such as saponin; anionic or nonionic surfactants such as alkylene oxide, glycerines and glycidols; cationic surfactants such as higher alkyl amines, quaternary ammonium salts, pyridine and other heterocyclics, phosphonium and sulfonium; anionic surfactants having an acidic group such as carboxylic acids, sulfonic acids, phosphoric acids, sulfates, phosphates; and ampholytic surfactants such as amino acids, aminosulfonic acids, and sulfates and phosphates of amino-alcohols.

Examples of the surfactant used herein are described in USP 2,271,623, 2,240,472, 2,288,226, 2,739,891, 3,068,101, 3,158,484, 3,201,253, 3,210,191, 3,294,540, 3,415,649, 3,441,413, 3,442,654, 3,475,774, and 3,545,574, UKP 1,077,317 and 1,198,450, Oda Ryohei et al., "Kaimen-Kasseizai No Gosei To Sono Oyo (Synthesis of Surfactants and their Application)", Maki-Shoten, 1964, A.W. Perry, "Surface Active Agent", Interscience Publication Inc., 1958, and J.P. Sisley, "Encyclopedia of Active Agent", Vol. 2, Chemical Publish Co., 1964. As previously described, filter dyes or anti-irradiation dyes may be contained in the offset printing material of the invention. Exemplary dyes are described in USP 2,274,782, 2,527,583, 2,956,879, 3,177,078 and 3,252,921 and JP-B 22069/1964. These dyes may be mordanted by the method described in USP 3,282,699, if desired. The anti-halation layer can be a colored layer containing a pigment such as lamp black, carbon black, fest black, ultramarine, Malachite Green, and Crystal Violet.

Any of well-known coating techniques may be used to coat layers on the support for constituting the offset printing material of the invention. Exemplary techniques include dipping, air knife, and extrusion doctor techniques, with the bead coating technique described in USP 2,761,791 being most preferred.

### EXAMPLE

Examples of the present invention are given below by way of illustration.

### Example 1

### Preparation of emulsions

Surface latent image type silver halide emulsions A to G were prepared by the following procedures.

### Emulsion A

An aqueous solution of potassium bromide and an aqueous solution of silver nitrate were simultaneously added to an aqueous gelatin solution at 50°C, obtaining an emulsion of cubic silver bromide (AgBr) grains having a mean grain size of 0.3 µm. After sedimentation and water washing, the emulsion was subject to chemical sensitization at 60°C by adding sodium thiosulfate and chloroauric acid tetrahydrate. There was obtained a surface latent image type silver halide emulsion A.

### Emulsion B

An aqueous mix of sodium chloride and potassium bromide and an aqueous solution of silver nitrate were simultaneously added to an aqueous gelatin solution at 50°C, obtaining an emulsion of cubic silver chlorobromide (AgBr₈₀Cl₂₀) grains having a mean grain size of 0.3 µm. After sedimentation and water washing, the emulsion was subject to chemical sensitization at 60°C by adding sodium thiosulfate and chloroauric acid tetrahydrate. There was obtained a surface latent image type silver halide emulsion B.

### Emulsions C to G

The procedure of Emulsion B was repeated except that the halogen composition was changed, obtaining Emulsion C (AgBr₆₀Cl₄₀), Emulsion D (AgBr₄₀Cl₆₀), Emulsion E (AgBr₂₀Cl₈₀), Emulsion F (AgBr₉₅Cl₅), and Emulsion G (AgCl).

### Manufacture of lithographic printing plates

A pre-treated polyester film support on one surface was coated with a matte layer containing silica particles having a mean particle size of 5 µm. The support on the other surface was coated with an anti-halation undercoat layer containing carbon black and 20% by weight based on the photographic gelatin of silica powder having a mean particle size of 7 µm and a layer of emulsion A to which 5.0x10⁻⁴ mol per mol of Ag of a sensitizing dye III-37 was added. The undercoat layer contained 3.1 g/m² of gelatin, and the emulsion layer contained 1.3 g/m² of gelatin and had a silver coverage of 1.2 g/m². Both the undercoat and emulsion layers used formalin as the hardener. On the emulsion layer, an acrylamide/imidazole copolymer solution containing PdS nuclei as physical development nuclei was coated and dried, obtaining a lithographic printing plate A-1.

The procedure of plate A-1 was repeated except that Emulsion A was replaced by Emulsions B to G, obtaining lithographic printing plates B-1, C-1, D-1, E-1, F-1, and G-1, respectively.

These lithographic printing plates were exposed to helium-neon laser light having a wavelength of 633 nm for 10⁻⁵ second through a neutral gray wedge in close contact with each plate.

Each of the lithographic printing plates was treated with a developer(s), removed of extra developer liquid, immediately thereafter treated with a neutralizing solution of the composition shown below at 25°C for 30 seconds, removed of extra solution through squeeze rollers, and dried at room temperature.

| Neutralizing solution | |
|---|---|
| Water | 600 ml |
| Citric acid | 11 g |
| Sodium citrate | 36 g |
| Colloidal silica (20% solution) | 6 ml |
| Ethylene glycol | 6 ml |
| Water totaling to | 1 liter |

The development systems used herein included the conventional single-bath development system and the two-bath development system according to the invention. Samples of each plate were developed by these systems, respectively. For development, there were prepared developers X-1 to X-11 which did not contain or did not substantially contain a silver halide solvent as shown in Table 1 and developers Y-1 to Y-19 which contained a silver halide solvent as shown in Table 2. These developers were used in combination as shown in Tables 3 to 5. Development was done in each bath at 30°C for 30 seconds.

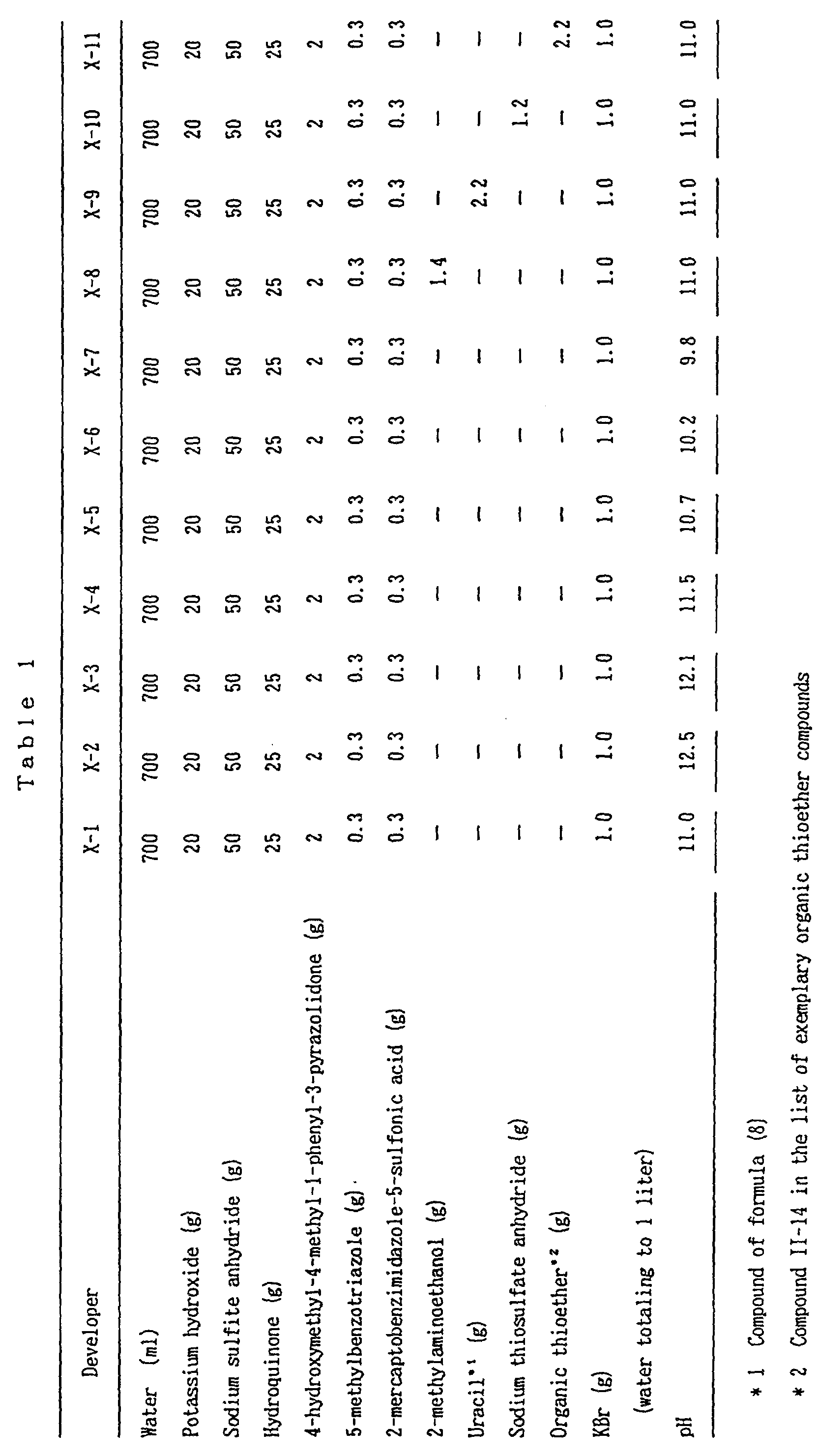

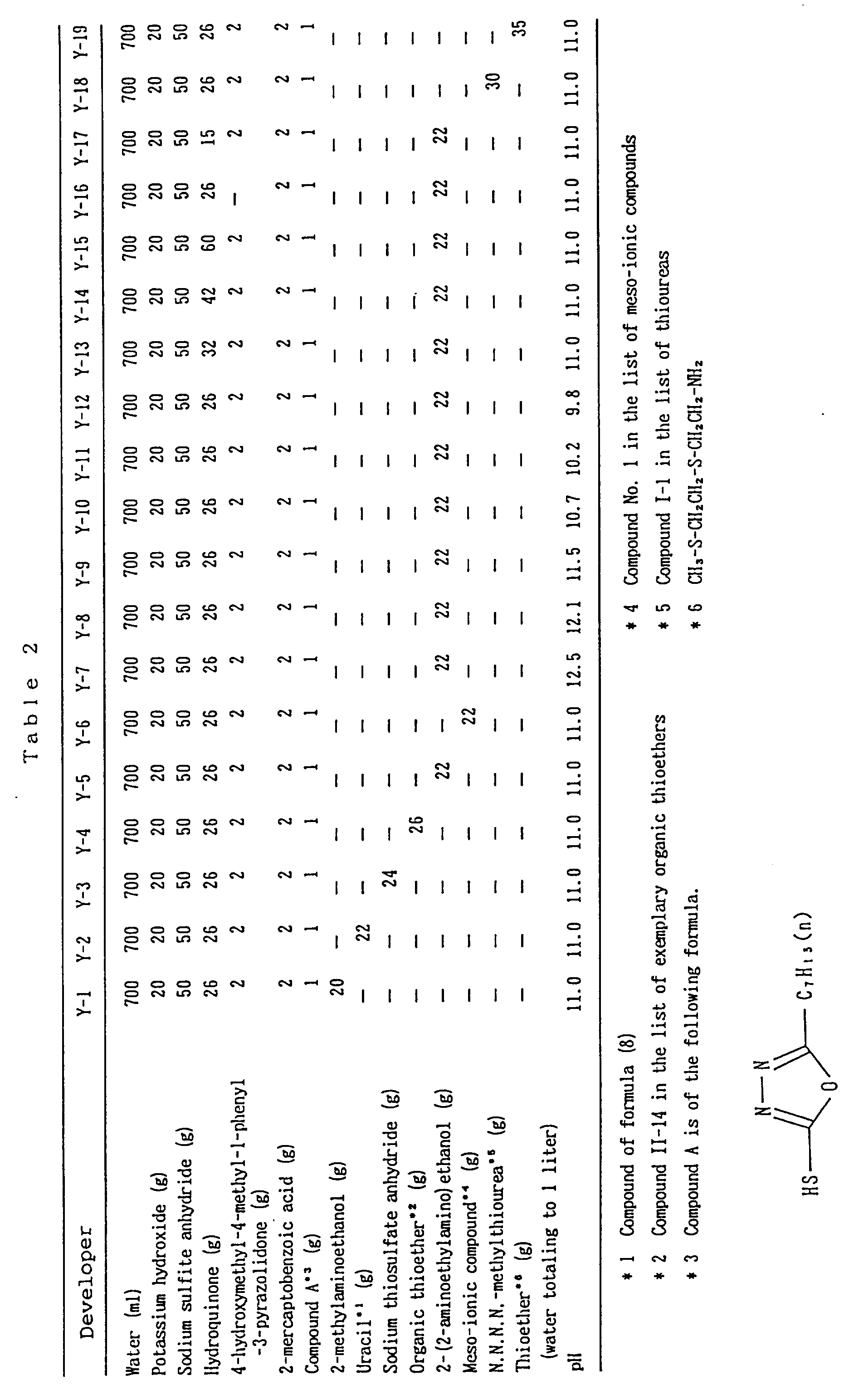

The lithographic printing plates were evaluated for printing properties in terms of resolving power and run length.

The resolving power was examined by using gray contact screens of 100, 133, 150, 175 and 200 lines/inch and determining the line number of the screen at which a fine network image (5% dot) could be clearly reproduced. The resolving power was evaluated in five ratings from rating 1 (100 lines/inch) to rating 5 (200 lines/inch).

Each lithographic printing plate prepared using a contact screen was mounted in an offset printing machine, and a desensitizing solution of the following composition was spread throughout the plate surface. The machine was operated for printing while dampening the plate with a fountain solution of the following composition.

| Desensitizing solution | |
|---|---|
| Water | 550 ml |
| Isopropyl alcohol | 450 ml |
| Ethylene glycol | 50 g |
| Compound A (below) | 1 g |

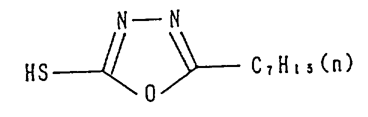

| Fountain solution | |
|---|---|
| o-phosphoric acid | 10 g |
| Nickel nitrate | 5 g |
| Sodium sulfite | 5 g |
| Ethylene glycol | 100 g |
| Colloidal silica (20% solution) | 28 g |
| Water totaling to | 2 liters |

The offset press was A. B. Dick 350CD (trade mark, by A. B. Dick Company). The run length or plate wear was evaluated in accordance with the following criterion based on the number of sheets at which scumming occurred or silver skips disabled printing.

### Run length criterion

- 1: up to 2,000 sheets
- 2: 2,001 to 4,000 sheets
- 3: 4,001 to 6,000 sheets
- 4: 6,001 to 8,000 sheets
- 5: 8,001 to 10,000 sheets
- 6: more than 10,000 sheets

The results are shown in Tables 3 to 5.

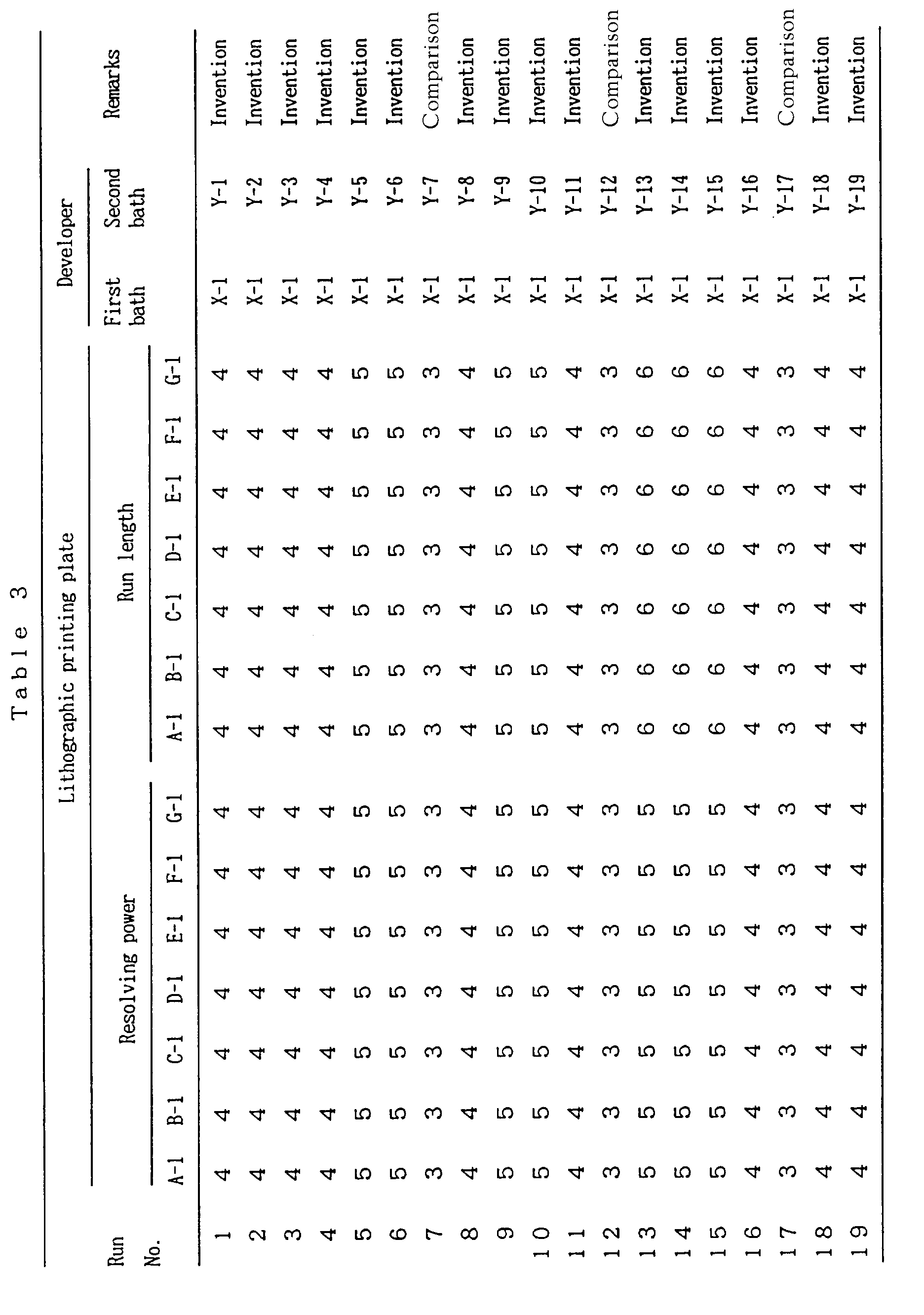

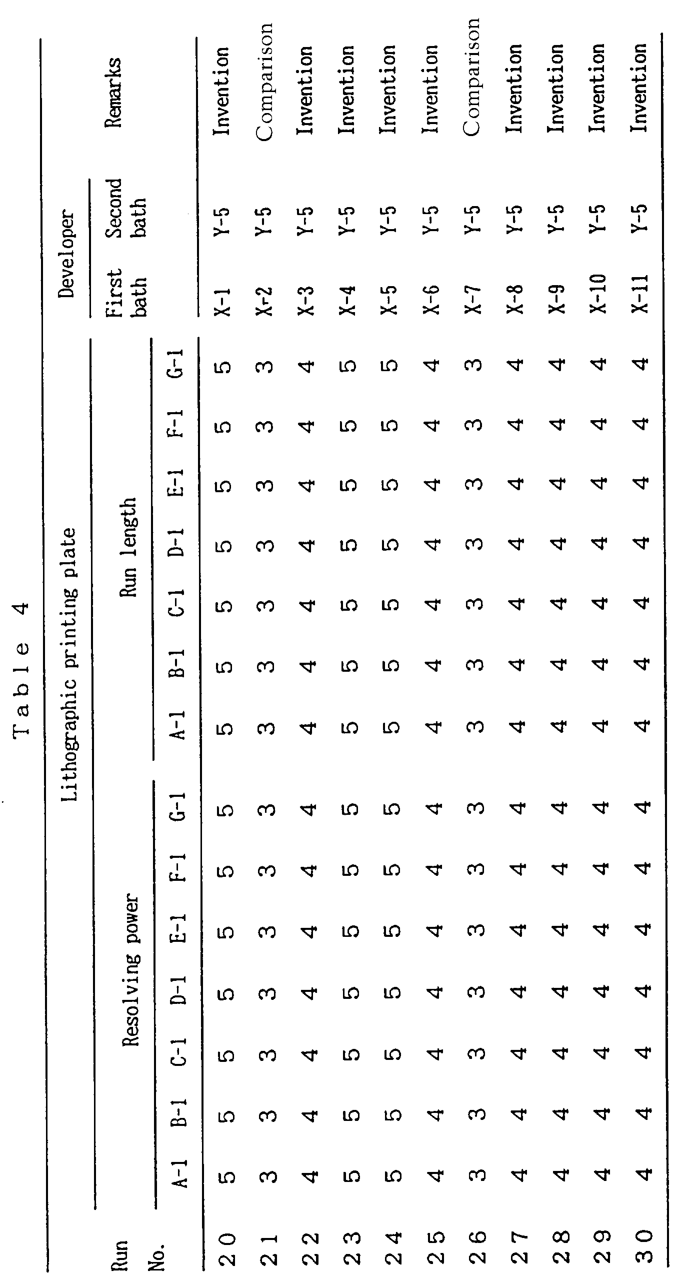

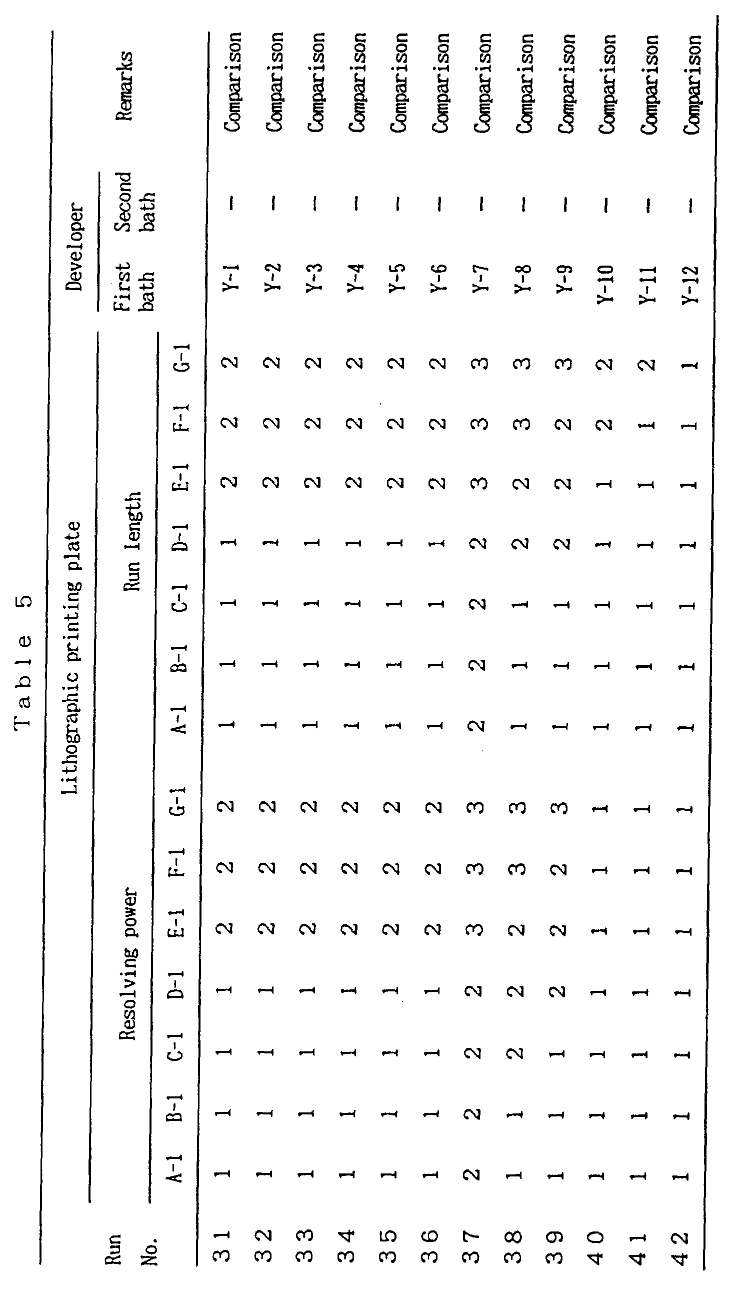

As seen from Tables 3 to 5, the two-bath development system according to the present invention accomplished significant improvements in resolving power and run length as compared with the conventional single-bath development system. With respect to the halogen composition, the single-bath development system favored a silver chloride system while the two-bath development system achieved satisfactory properties with any composition without relying on a particular halogen composition. It is also seen that better results are obtained with processing solutions in a preferred pH range.

In the single-bath development system, an automatic processor for printing plate preparation could not be used without modification while the two-bath development system allowed an automatic processor (for example, model FG680A manufactured by Fuji Photo-Film Co., Ltd.) to be used as such.

### Example 2

Lithographic printing plates A-2 to G-2 were manufactured by repeating the procedures of lithographic printing plates A-1 to G-1 in Example 1 except that 6x10⁻⁵ mol/mol of Ag of sensitizing dye IV-3 was used instead of sensitizing dye III-37 and 1.5x10⁻⁴ mol/mol of Ag of a compound of the following formula was added to the emulsion layer.

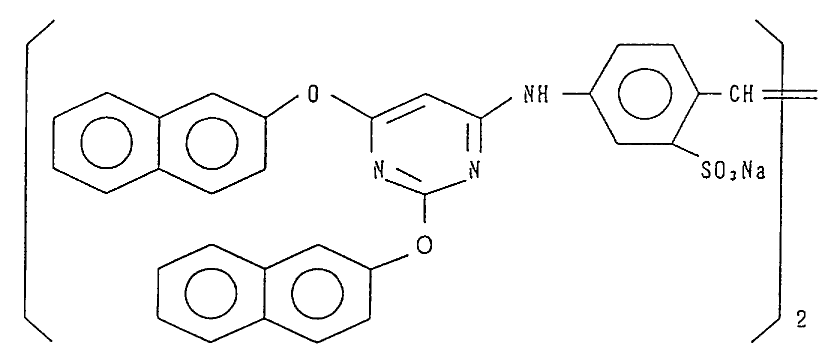

These lithographic printing plates were evaluated for resolving power and run length by the same procedures as in Example 1 except that a semiconductor laser of 780 nm oscillation was used upon exposure. The results are shown in Table 6.

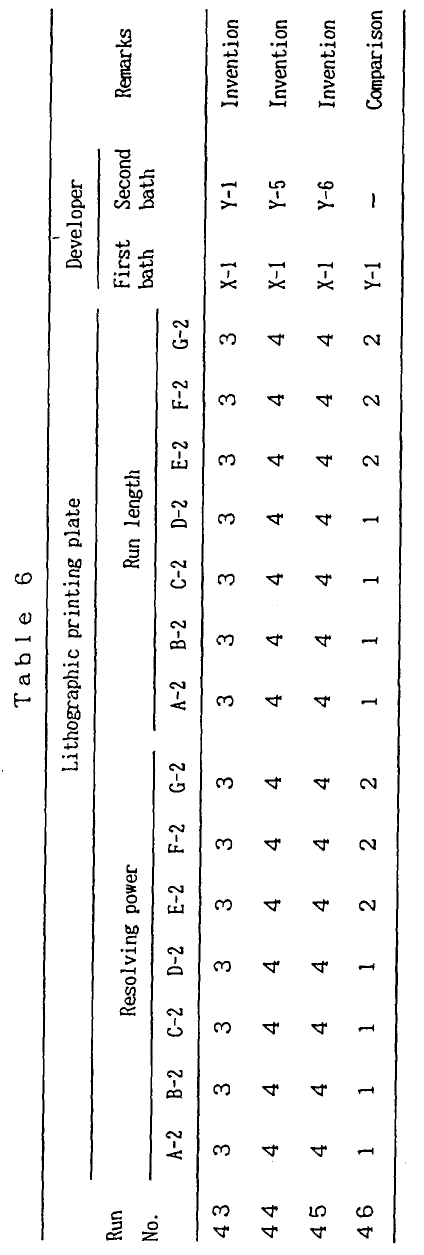

It is seen that when a semiconductor laser was used, the two-bath development system also exhibited better printing properties than the single-bath development system.

### Example 3

Lithographic printing plates A-3 to G-3 were manufactured by repeating the procedures of lithographic printing plates A-1 to G-1 in Example 1 except that 2x10⁻⁴ mol/mol of Ag of sensitizing dye III-31 was used instead of sensitizing dye III-37.

These lithographic printing plates were evaluated for resolving power and run length by the same procedures as in Example 1 except that an argon gas laser of 488 nm oscillation was used upon exposure. The results are shown in Table 7.

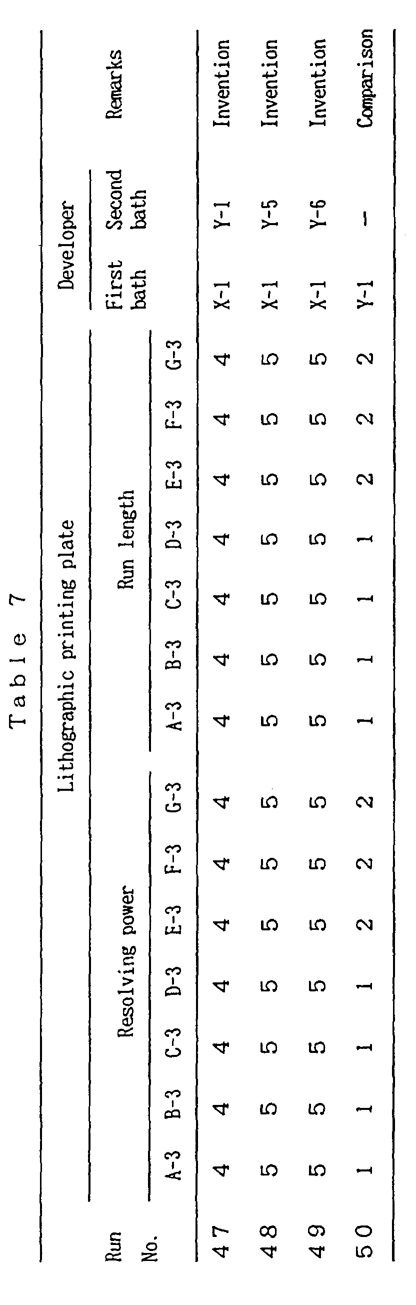

It is seen that when an Ar gas laser was used, the two-bath development system also exhibited better printing properties than the single-bath development system.

### Example 4

Emulsions A' to G' were prepared by the same procedures as Emulsions A to G, respectively, except that grains were formed in the presence of ammonium iridium (IV) chloride for doping the grains with Ir in an amount of 1.7x10⁻⁷ mol per mol of Ag. Lithographic printing plates A'-1 to G'-1 were manufactured by repeating the procedures of lithographic printing plates A-1 to G-1 in Example 1 except that Emulsions A' to G' were used, processed as in Example 1 in accordance with the combinations shown in Table 8, and evaluated for printing properties. The results are shown in Table 8.

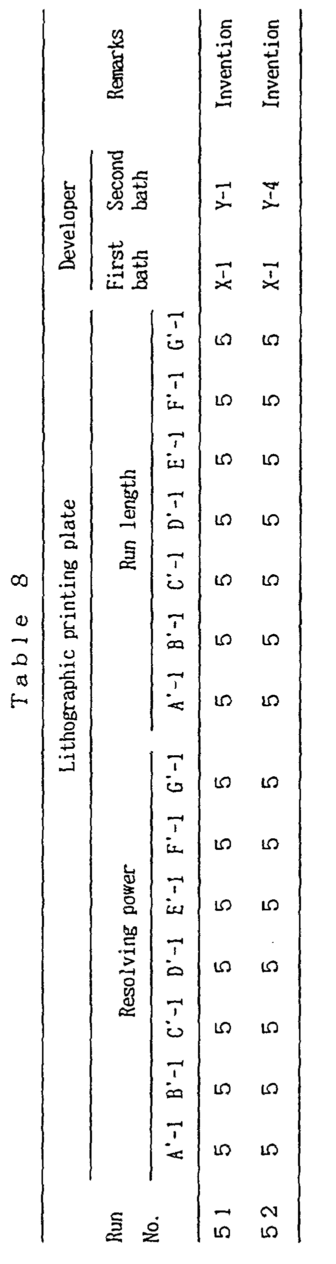

It is evident from Table 8 that the iridium doping is effective for improving resolving power and run length.

### Example 5

Emulsions A'' to G'' were prepared by the same procedures as Emulsions A to G, respectively, except that grains were formed in the presence of ammonium iridium (IV) chloride and ammonium rhodium (III) chloride for doping the grains with Ir in an amount of 1.5x10⁻⁷ mol per mol of Ag and Rh in an amount of 1.2x10⁻⁸ mol per mol of Ag. Lithographic printing plates A''-1 to G''-1 were manufactured by repeating the procedures of lithographic printing plates A-1 to G-1 in Example 1 except that Emulsions A'' to G'' were used, processed as in Example 1 in accordance with the combinations shown in Table 9, and evaluated for printing properties. The results are shown in Table 9.

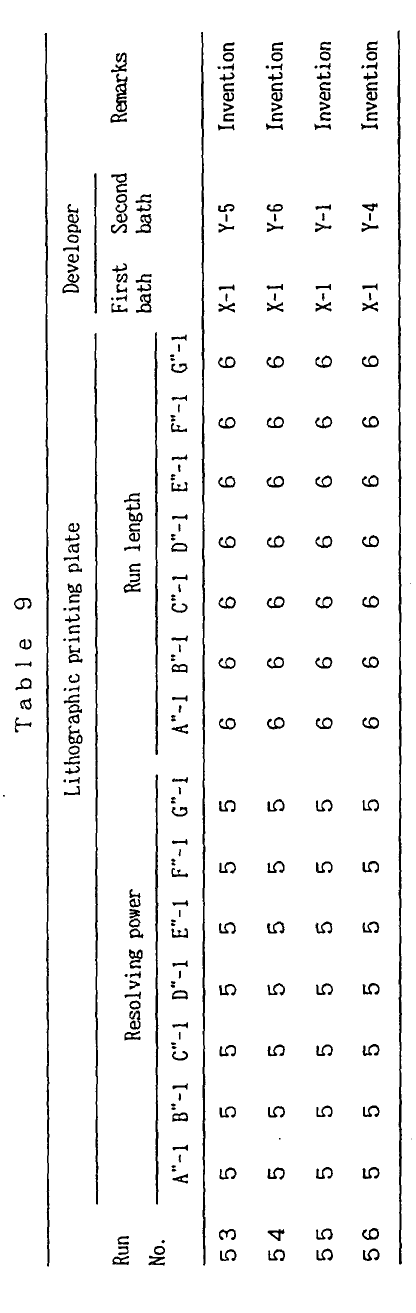

It is evident from Table 9 that the combined iridium and rhodium doping is effective for further improving resolving power and run length.

### Example 6

While lithographic printing plates A'-1 to G'-1 of Example 4 were processed by the same combination as Run No. 51 (Table 8) and evaluated, the optimum quantity of laser light for the lithographic printing plate as photosensitive material was determined. The light quantity was reported in Table 10 as a relative value based on a light quantity of 100 for plate G'-1.

**Table 10**

| Lithographic printing plate | Light quantity |
|---|---|
| A'-1 | 30 |
| B'-1 | 30 |
| C'-1 | 40 |
| D'-1 | 50 |
| E'-1 | 95 |
| G'-1 | 100 |

It is evident from Table 10 that a silver halide composition with an increased silver chloride content exhibits lower sensitivity at high illumination intensity.

### Example 7

Lithographic printing plates A-4 to G-4 were manufactured by the same procedures as lithographic printing plates A-1 to G-1 except that hydroquinone was incorporated in the physical development nucleus layer to provide a coverage of 0.8 g/m² upon coating. The plates were exposed, processed, and determined for printing properties and optimum light quantity as in Example 1 except that in the processing stage, instead of the developer, each plate was processed with an activator of the following composition at 25°C for 20 seconds.

| Activator | |
|---|---|
| Water | 700 ml |
| Potassium hydroxide | 20 g |
| Sodium sulfite anhydride | 50 g |
| 2-mercaptobenzoic acid | 1.5 g |
| 2-methylaminoethanol | 15 ml |
| Water totaling to | 1 liter |

The results are shown in Table 11 together with the results of Run No. 6 in Example 1. The ratings of resolving power and run length are the same as in Example 1 and the optimum light quantity is a relative value.

**Table 11**

| Printing properties | | | | |
|---|---|---|---|---|
| Printing plate | Resolving power | Run length | Light quantity | Remarks |
| A-4 | 1 | 1 | 90 | Activator |
| B-4 | 1 | 1 | 95 | Activator |
| C-4 | 1 | 1 | 100 | Activator |
| D-4 | 1 | 1 | 110 | Activator |
| E-4 | 1 | 1 | 120 | Activator |
| F-4 | 2 | 2 | 145 | Activator |
| G-4 | 2 | 2 | 150 | Activator |
| A-1 | 5 | 5 | 45 | Two-bath development |
| B-1 | 5 | 5 | 45 | Two-bath development |
| C-1 | 5 | 5 | 50 | Two-bath development |
| D-1 | 5 | 5 | 50 | Two-bath development |
| E-1 | 5 | 5 | 60 | Two-bath development |
| F-1 | 5 | 5 | 96 | Two-bath development |
| G-1 | 5 | 5 | 100 | Two-bath development |

It is evident from Table 11 that the activator treatment afforded lower sensitivity and inferior printing properties to the present invention.

Aging properties were also examined. Lithographic printing plates A-1 to G-1 and A-4 to G-4 were stored for 3 days at 50°C and RH 70% and then examined for sensitivity and printing properties. Lithographic printing plates A-4 to G-4 having hydroquinone incorporated therein experienced a further lowering of sensitivity and exacerbated the resolving power and run length which were poor from the initial. In contrast, lithographic printing plates A-1 to G-1 which were free of hydroquinone experienced little loss of properties after storage or remained sound.

Strictly stating, a comparison of lithographic printing plates A-1 to G-1 before and after aging shows that although they both gave rise to no problem in practice and exhibited satisfactory properties, there was a tendency that properties were more deteriorated by aging as the silver halide composition of the emulsion layer lowered its Br content.

There were obtained equivalent results to these results including the data of Table 11 when iridium-doped emulsions as in Example 4 were used.

By employing the two-bath development system, the present invention provides a lithographic printing material with high sensitivity and improvements in resolving power and printing wear. The lithographic printing material is compatible with high-illumination intensity light sources such as lasers emitting light of varying wavelengths. The method of the invention have many benefits including stability, safety and ease of handling.

## Claims

1. A method for processing a lithographic printing material having at least a silver halide emulsion layer and a physical development nucleus layer on a support by a processing procedure including at least development in accordance with a silver salt diffusion transfer process, wherein
said development is carried out in two baths, the first bath uses a developer which does not induce substantial diffusion transfer development, and the second bath uses a developer which contains a silver halide solvent necessary to induce diffusion transfer development, characterised in that each of the first and second bath developers is at pH 10.0 to 12.3 and contains at least 20 g/l of hydroquinone.

2. The method of claim 1 wherein a negative silver halide emulsion is used whereby a positive transfer silver image is produced.

3. The method of claim 2 wherein a negative emulsion being of the surface latent image type is used.

4. The method of any of claims 1 to 3 wherein a silver halide emulsion including a silver halide containing at least 20 mol% of Br is used.

5. The method of any of claims 1 to 4 wherein a silver halide emulsion containing iridium is used.

6. The method of claim 5 wherein a silver halide emulsion further containing rhodium is used.

7. The method of any of claims 1 to 6 wherein a lithographic printing material containing a sensitizing dye is used.

## Patentansprüche

1. Ein Bearbeitungsverfahren für ein lithographisches Druckmaterial, das wenigstens eine Silberhalogenid-Emulsionsschicht und eine physikalische Entwicklungs-Keimschicht auf einem Träger aufweist, über einen Bearbeitungsprozeß, der wenigstens die Entwicklung gemäß einem Silbersalzdiffusions-transferverfahren einschließt, wobei die Entwicklung in zwei Bädern durchgeführt wird, wobei das erste Bad einen Entwickler verwendet, der keine merkliche Diffusionstransferentwicklung hervorruft, und wobei das zweite Bad einen Entwickler verwendet, der ein Silberhalogenidlösungsmittel enthält, das notwendig ist, um eine Diffusionstransferentwicklung hervorzurufen, gekennzeichnet dadurch, daß jeder Erst- und Zweitbadentwickler einen pH von 10,0 bis 12,3 hat und wenigstens 20 g/l an Hydrochinon enthält.

2. Das Verfahren nach Anspruch 1, wobei eine Negativ-Silberhalogenidemulsion verwendet wird, wodurch ein Positivtransfersilberbild hergestellt wird.

3. Das Verfahren nach Anspruch 2, wobei eine Negativemulsion der Art eines Oberflächenlatentbildes verwendet wird.

4. Das Verfahren nach einem der Ansprüche 1 bis 3, wobei eine Silberhalogenidemulsion, die ein Silberhalogenid, das wenigstens 20 mol% Br enthält, beinhaltet, verwendet wird.

5. Das Verfahren nach einem der Ansprüche 1 bis 4, wobei eine Silberhalogenidemulsion verwendet wird, die Iridium enthält.

6. Das Verfahren nach Anspruch 5, wobei eine Silberhalogenidemulsion verwendet wird, die darüber hinaus Rhodium enthält.

7. Das Verfahren nach einem der Ansprüche 1 bis 6, wobei ein lithographisches Druckmaterial, das einen sensibilisierenden Farbstoff enthält, verwendet wird.

## Revendications

1. Procédé de traitement d'un matériau d'impression lithographique ayant au moins une couche d'émulsion à l'halogénure d'argent et une couche de noyau de développement physique sur un support par une procédure de traitement comprenant au moins le développement selon un procédé de transfert par diffusion de sel d'argent, où
ledit développement est réalisé dans deux bains, le premier bain utilise un développateur qui n'induit pas sensiblement de développement par transfert par diffusion, et le second bain utilise un développateur qui contient un solvant d'halogénure d'argent nécessaire pour provoquer le développement par transfert par diffusion, caractérisé en ce que chacun du premier et du second bain de développateur est à un pH de 10,0 à 12,3 et contient au moins 20 g/l d'hydroquinone.

2. Procédé selon la revendication 1 où une émulsion à l'halogénure d'argent négative est utilisée où on produit une image d'argent positive par transfert.

3. Procédé selon la revendication 2 où on utilise une émulsion négative qui est du type à image latente superficielle.

4. Procédé selon l'une quelconque des revendications 1 à 3 où on utilise une émulsion à l'halogénure d'argent comprenant de l'halogénure d'argent qui contient au moins 20 % molaire de Br.

5. Procédé selon l'une quelconque des revendications 1 à 4, où on utilise une émulsion à l'halogénure d'argent contenant de l'iridium.

6. Procédé selon la revendication 5 où on utilise une émulsion à l'halogénure d'argent qui contient en plus du rhodium.

7. Procédé selon l'une quelconque des revendications 1 à 6 où on utilise un matériau d'impression lithographique contenant un colorant sensibilisant.
